# EUROPEAN PATENT APPLICATION

(11) **EP 1 737 024 A1**
(43) Date of publication of application: **27.12.2006**
(21) Application number: 05721450.4
(22) Date of filing: 25.03.2005
(51) Int. Cl.: H01L 21/027, G03F 7/20

(54) **EXPOSURE EQUIPMENT, EXPOSURE METHOD AND DEVICE MANUFACTURING METHOD**

(30) Priority: 25.03.2004 JP 2004088282
(71) Applicant: NIKON CORPORATION, Tokyo 100-8331 (JP)
(72) Inventor: SHIBAZAKI, Yuichi, Chiyoda-ku, Tokyo 1008331 (JP)
(74) Representative: Gill, David Alan
(86) International application number: PCT/JP2005/005473
(87) International publication number: WO 2005/093792

(57) **Abstract**

Of a measurement stage (MST) that has a plate (101) on which liquid is supplied, and performs measurement related to exposure via a projection optical system (PL) and a liquid (Lq), at least a part of the measurement stage including the plate can be exchanged. Therefore, by exchanging at least a part of the measurement stage including the plate before the surface of the plate deteriorates due to contact with the liquid, measurement related to exposure can be performed constantly with high precision, which makes it possible to maintain exposure with high precision. Further, in the case at least one edge surface of the plate is mirror-polished, when at least a part of the measurement section including the plate is exchanged to a new component, the position of the plate can be accurately measured, for instance, by an interferometer or the like via the edge surface of the plate that has been mirror-polished, even if the position of the component that has been exchanged is roughly set.

## Description

### TECHNICAL FIELD

The present invention relates to exposure apparatus and exposure methods, and device manufacturing methods, and more particularly to an exposure apparatus and an exposure method used in a lithography process when manufacturing electronic devices such as a semiconductor device (an integrated circuit), a liquid crystal display device and the like, and a device manufacturing method using the exposure apparatus.

### BACKGROUND ART

Conventionally, in a lithographic process for manufacturing electronic devices such as a semiconductor device (an integrated circuit), a liquid crystal display device or the like, exposure apparatus such as a reduction projection exposure apparatus by a step-and-repeat method (the so-called stepper) that transfers an image of a pattern of a mask (or a reticle) via a projection optical system onto each of a plurality of shot areas on a photosensitive object such as a wafer or a glass plate (hereinafter referred to as a "wafer") on which a resist (a photosensitive material) is coated, or a projection exposure apparatus by a step-and-scan method (the so-called scanning stepper (also called a scanner)), are mainly used.

In these types of projection exposure apparatus, a higher resolving power (resolution) is required year by year to cope with finer patterns due to higher integration of integrated circuits. This gradually brought forward a situation where exposure light requires a shorter wavelength and the projection optical system requires an increase in numerical aperture (NA) (a larger NA). However, although such shorter wavelength of the exposure light and increase in the numerical aperture improves the resolution of the projection exposure apparatus, it also causes a decrease in depth of focus. Further, it is presumed that the wavelength will become much shorter in the future, and if the situation continues, the depth of focus could become so small that focus margin shortage would occur during the exposure operation.

Therefore, as a method of substantially shortening the exposure wavelength while increasing (widening) the depth of focus when compared with the depth of focus in the air, the exposure apparatus that uses the immersion method is recently gathering attention. As such an exposure apparatus using the immersion method, the apparatus that performs exposure in a state where the space between the lower surface of the projection optical system and the wafer surface is locally filled with liquid such as water or an organic solvent is known (for example, refer to Patent Document 1 below). According to the exposure apparatus of Patent Document 1, the resolution can be improved by making use of the fact that the wavelength of the exposure light in the liquid becomes 1/n of the wavelength in the air (n is the refractive index of the liquid which is normally around 1.2 to 1.6), and the depth of focus can be also substantially increased n times when compared with the case where the same resolution is obtained by a projection optical system (supposing that such a projection optical system can be made) that does not employ the immersion method, that is, the depth of focus can be substantially increased n times than in the air.

Further, proposals are recently made of an exposure apparatus that is equipped with a stage (a measurement stage), which can be driven within a two-dimensional plane independently from a wafer stage (a substrate stage), and on which a measurement instrument used for measurement is arranged (for example, refer to Patent Documents 2, 3 and the like). In the case this measurement stage is employed, the wafer stage needs only the minimum components (e.g. a wafer holder) that will be necessary when exposing the wafer, therefore, the size and the weight of the wafer stage can be reduced. Accordingly, the size of the drive mechanism (a motor) that drives the wafer stage and the amount of heat generated from the motor can both be reduced, and it is anticipated that thermal deformation or deterioration in exposure accuracy can be suppressed as much as possible.

However, in the case the measurement stage is employed in the immersion exposure apparatus, since various measurements related to exposure are performed in a state where the measurement stage is immersed in water, it is highly probable that the surface of the member of the measurement stage that comes into contact with the liquid deteriorates due to the contact with the liquid and the irradiation of the exposure light, and the measurement accuracy of various measurements related to exposure deteriorates over time, which makes it difficult to maintain the exposure accuracy for a long period. The upper surface of each measurement instrument section on the measurement stage is naturally coated with a water repellent, however the durability of this water-repellent coating is poor to the exposure light normally used in the immersion exposure apparatus (light in the far ultraviolet region or the vacuum ultraviolet region) and the coating has a nature of deteriorating by the irradiation of the exposure light.

Also even in the case of when various measurement instruments are arranged on the wafer stage without employing the measurement stage, the phenomenon in which the surface of the member that comes into contact with the liquid (in most cases, the water-repellent coating is applied to the surface of this member) deteriorates due to the contact with the liquid and the irradiation of the exposure light and the measurement accuracy of various measurements related to exposure deteriorates over time can occur, as in the case described above.
Patent Document 1: the pamphlet of International Publication No. WO99/49504,
Patent Document 2: Kokai (Japanese Unexamined Patent Application Publication) No. 11-135400, and
Patent Document 3: Kokai (japanese Unexamined Patent Application Publication) No. 03-211812.

### DISCLOSURE OF INVENTION

### MEANS FOR SOLVING THE PROBLEMS

The present invention has been made in consideration of the situation described above, and according to a first aspect of the present invention, there is provided a first exposure apparatus that exposes a substrate via a projection optical system, the apparatus comprising: a substrate stage that can move with the substrate mounted; and a measurement section that has a plate on which a liquid is supplied and performs measurement related to the exposure via the projection optical system and the liquid, wherein the apparatus is configured so that at least a part including the plate that constitutes the measurement section can be exchanged.

With this apparatus, of the measurement section that has a plate on which a liquid is supplied and performs measurement related to exposure via a projection optical system and the liquid, a part of the measurement section including the plate can be exchanged. Therefore, by exchanging a part of the measurement section including the plate before the surface of the plate deteriorates due to contact with the liquid, measurement related to exposure can be constantly performed with high precision, which makes it possible to maintain exposure with high precision.

According to a second aspect of the present invention, there is provided a second exposure apparatus that exposes a substrate via a projection optical system, the apparatus comprising: a substrate stage that can move with the substrate mounted; and a measurement section that has a plate on which mirror-polishing is applied on at least one edge surface, and performs measurement related to the exposure via the projection optical system, wherein the apparatus is configured so that at least a part including the plate that constitutes the measurement section can be exchanged.

With this apparatus, because a part of the measurement section including the plate that constitutes the measurement section can be exchanged, by exchanging a part of the measurement section including the plate before the surface of the plate deteriorates due to irradiation of the exposure light during measurement or the like, measurement related to exposure can be constantly performed with high precision, which makes it possible to maintain exposure with high precision. Further, because at least one of the edge surfaces of the plate is mirror-polished, the position of the plate can be accurately measured, for instance, by an interferometer or the like via the edge surface of the plate that has been mirror-polished when at least a part of the measurement section including the plate is exchanged to a new component, even if the position of the component that has been exchanged is roughly set. Accordingly, even if the plate is roughly positioned during the exchange, because it is possible to accurately position the measurement section at a desired position on measurement, it is no longer necessary to take a lot of time in the exchange operation, and it becomes possible to effectively prevent a reduction in the apparatus operation efficiency caused by the increasing downtime that accompanies the exchange.

According to a third aspect of the present invention, there is provided a third exposure apparatus that exposes a substrate via a projection optical system, the apparatus comprising: a substrate stage that can move with the substrate mounted; a measurement section that has a plate that can be exchanged, and performs measurement related to the exposure via the projection optical system; and a detection unit that detects an exchange timing of the plate.

With this apparatus, by obtaining the period just before the measurement accuracy of the measurement section begins to deteriorate in advance by experiment or the like, setting this period in advance as the exchange timing of the plate detected by the detection unit, and exchanging the plate when the detection unit detects the coming of the period, it becomes possible to exchange the plate during the optimum period, which is before the deterioration of the measurement accuracy of the measurement section. That is, the measurement accuracy of the measurements related to exposure performed by the measurement section can be maintained with high precision, and the exchange frequency of the plate can also be suppressed as much as possible. Accordingly, the exposure accuracy can be maintained with high precision over a long period of time, and it also becomes possible to effectively prevent a reduction in the apparatus operation efficiency caused by the increasing downtime that accompanies the plate exchange.

According to a fourth aspect of the present invention, there is provided a first exposure method in which a substrate is exposed, the method comprising: an exchange process in which of a measurement section that performs measurement related to the exposure via a plate on which a liquid is supplied, at least a part including the plate is exchanged; and an exposure process in which measurement related to the exposure is performed using the measurement section after the exchange, and the substrate is exposed reflecting the measurement results.

With this method, of the measurement section that performs measurement related to the exposure via the plate on which the liquid is supplied, by exchanging a part of the measurement section including the plate before the surface of the plate deteriorates due to contact with the liquid, measurement related to exposure can be constantly performed with high precision, and by reflecting the measurement results, exposure with high precision becomes possible.

According to a fifth aspect of the present invention, there is provided a second exposure method in which a substrate is exposed, the method comprising: an exchange process in which of a measurement section that performs measurement related to the exposure via a plate that has at least one edge surface mirror-polished, at least a part including the plate is exchanged; a measurement process in which a position of the plate after the exchange is measured via the edge surface, and the measurement is performed using the measurement section; and an exposure process in which the measurement results are reflected and the substrate is exposed.

With this method, by exchanging at least a part of the measurement section including the plate before the surface of the plate deteriorates due to irradiation of the exposure light during measurement or the like, measuring the position of the plate via the edge surface, and performing measurement related to exposure using the measurement section, measurement related to exposure can be performed with high precision. Also, when at least a part of the measurement section including the plate is exchanged to a new component, the position of the plate can be accurately measured, for instance, by an interferometer or the like via the edge surface of the plate that has been mirror-polished even if the position of the component that has been exchanged is roughly set. Accordingly, even if a part of the measurement section is roughly positioned during the exchange, it becomes possible to accurately position the measurement section at a desired position on measurement. Further, exposure with high precision becomes possible by reflecting the measurement results.

According to a sixth aspect of the present invention, there is provided a third exposure method in which a substrate is exposed, the method comprising: a measurement process in which measurement is performed using a measurement section that performs measurement related to the exposure via a plate; an exchange process in which an exchange timing of the plate is detected and the plate is exchanged; and an exposure process in which the substrate is exposed with the measurement results reflected.

With this method, the period just before the measurement accuracy of the measurement section begins to deteriorate is obtained in advance by experiment or the like, and this period is to be set in advance as the exchange timing of the plate. Then, by exchanging the plate when the exchange timing is detected, it becomes possible to exchange the plate during the optimum period, which is before the deterioration of the measurement accuracy of the measurement section. That is, the measurement accuracy of the measurements related to exposure performed by the measurement section can be maintained with high precision, and the exchange frequency of the plate can also be suppressed as much as possible. Further, exposure with high precision becomes possible by reflecting the measurement results.

Further, in a lithography process, by exposing a substrate using the first to third exposure apparatus of the present invention and forming a device pattern on the substrate, it becomes possible to improve the productivity of highly integrated microdevices. Accordingly, further from another aspect, it can be said that the present invention is also a device manufacturing method that uses any one of the first to third exposure apparatus of the present invention.

### BRIEF DESCRIPTION OF THE DRAWINGS

FIG. 1 is a schematic view of an exposure apparatus related to a first embodiment.
FIG. 2 is a perspective view of a stage unit.
FIG. 3A is a perspective view of a measurement stage.
FIG. 3B is a perspective view that shows a state of a measurement table detached from the measurement stage.
FIG. 4 is a longitudinal sectional view of the measurement stage.
FIG. 5 is a longitudinal sectional view of a self-weight canceller.
FIG. 6 is view modeled for describing an operation of the self-weight canceller.
FIG. 7 is a block diagram that shows a main configuration of a control system of the exposure apparatus of the first embodiment.
FIG. 8A is a planar view (No. 1) for describing a parallel processing operation in the first embodiment.
FIG. 8B is a planar view (No. 2) for describing the parallel processing operation in the first embodiment.
FIG. 9A is a planar view (No. 3) for describing the parallel processing operation in the first embodiment.
FIG. 9B is a planar view (No. 4) for describing the parallel processing operation in the first embodiment.
FIG. 10 is a planar view (No. 3) for describing the parallel processing operation in the first embodiment.
FIG. 11 is a perspective view that shows a measurement stage and a load/unload mechanism related to a second embodiment.
FIG. 12 is a perspective view that shows a state where a plate is carried out from the measurement stage.

### BEST MODE FOR CARRYING OUT THE INVENTION

### <A First Embodiment>

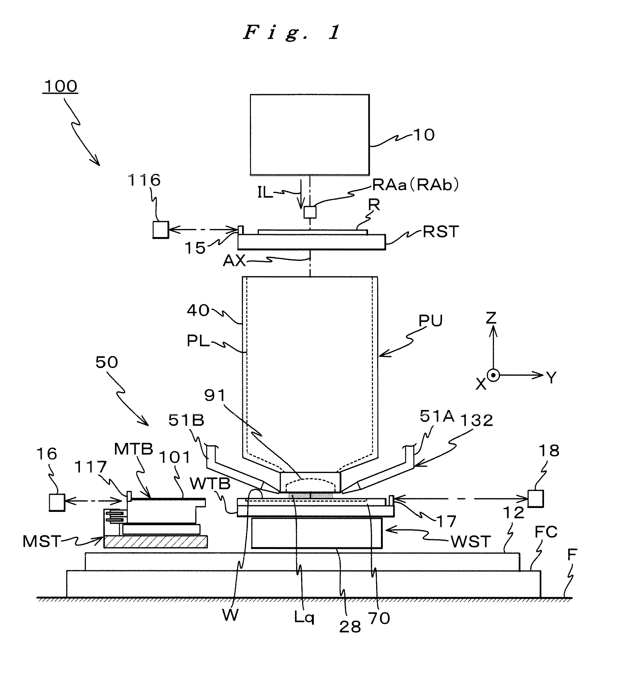

A first embodiment of the present invention will be described, referring to FIGS. 1 to 10.

FIG. 1 shows the entire configuration of an exposure apparatus 100 of the first embodiment. Exposure apparatus 100 is a projection exposure apparatus by a step-and-scan method, that is, the so-called scanning stepper (also referred to as a scanner). Exposure apparatus 100 is equipped with an illumination system 10, a reticle stage RST that holds a reticle R serving as a mask, a projection unit PU, a stage unit 50 that has a wafer stage WST serving as a substrate stage and a measurement stage MST that constitutes a measurement section, a control system for the parts and the like. On wafer stage WST, a wafer W serving as a substrate is to be mounted.

Illumination system 10 illuminates a slit-shaped illumination area set by a reticle blind (not shown) with an illumination light (exposure light) IL with a substantially uniform illumination. As illumination light IL, as an example, an ArF excimer laser beam (wavelength 193 nm) is used.

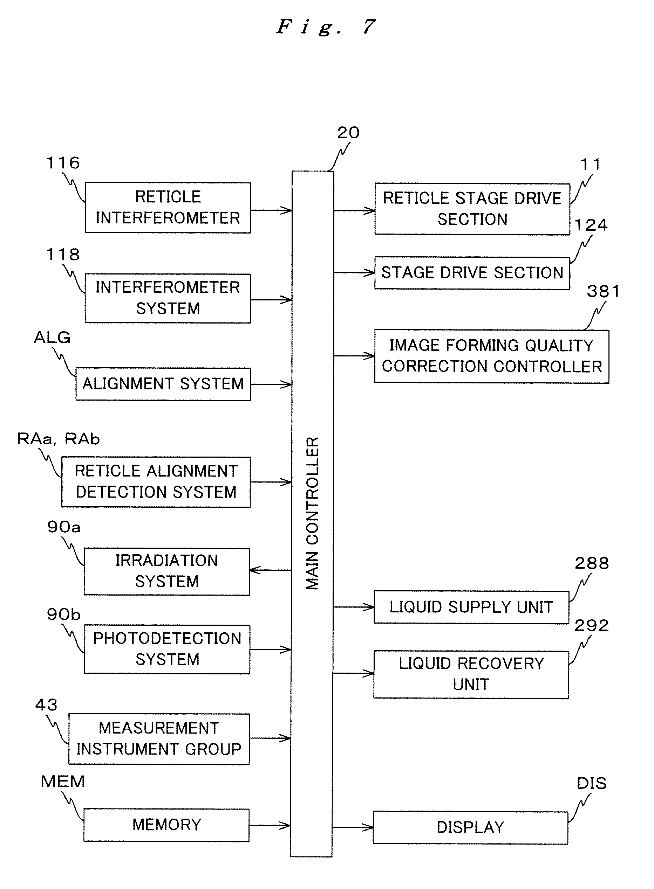

On reticle stage RST, reticle R that has a circuit pattern or the like formed on the pattern surface (the lower surface in FIG. 1) is fixed, for example, by vacuum suction. Reticle stage RST can be driven finely in an XY plane perpendicular to an optical axis of illumination system 10 (coincides with an optical axis AX of a projection optical system PL which will be described later), for example, by a reticle stage drive section 11 (not shown in FIG. 1, refer to FIG. 7) which includes a linear motor or the like, and can also be driven in a predetermined scanning direction (in this case, a Y-axis direction which is the lateral direction in FIG. 1) at a designated scanning speed.

The position of reticle stage RST (including rotation around a Z-axis) within a stage moving plane is constantly detected by a reticle laser interferometer (hereinafter referred to as a "reticle interferometer"), for example, at a resolution of around 0.5 to 1 nm, via a movable mirror 15 (a Y movable mirror that has a reflection surface orthogonal to a Y-axis direction and an X movable mirror that has a reflection surface orthogonal to an X-axis direction are actually arranged). Measurement values of reticle interferometer 116 is sent to a main controller 20 (not shown in FIG. 1, refer to FIG. 7), and based on the measurement values, main controller 20 computes the position of reticles stage RST in the X-axis direction, the Y-axis direction, and a θz direction (the rotation direction around the Z-axis; and also controls the position (and speed) of reticle stage RST by controlling reticle stage drive section 11 based on the computation results.

Above reticle R, a pair of reticle alignment detection systems RAa and RAb consisting of TTR (Through The Reticle) alignment systems that use light of the exposure wavelength so as to simultaneously observe a pair of reticle alignment marks and a pair of fiducial marks on measurement stage MST that correspond to the reticle alignment marks (hereinafter referred to as "a first fiducial mark") via projection optical system PL is arranged spaced a predetermined distance apart in the X-axis direction. As these reticle alignment detection systems RAa and RAb, a system is used that has a configuration similar to the one disclosed in, for example, Kokai (Japanese Unexamined Patent Application Publication) No. 07-176468 and the corresponding U.S. Patent No. 5,646,413 and the like. As long as the national laws in designated states (or elected states), on which this international application is applied, permit, the above disclosures of the publication and the corresponding U.S. Patent are incorporated herein by reference.

Projection unit PU is arranged below reticle stage RST in FIG. 1. Projection unit PU is configured including a barrel 40, and projection optical system PL consisting of a plurality of optical elements held in a predetermined positional relation within barrel 40. As projection optical system PL, a dioptric system is used consisting of a plurality of lenses (lens elements) that share an optical axis AX in the Z-axis direction. Projection optical system PL is, for example, a both-side telecentric dioptric system that has a predetermined projection magnification (such as one-quarter or one-fifth times) is used. Therefore, when illumination light IL from illumination system 10 illuminates the illumination area on reticle R, by illumination light IL that has passed through reticle R, a reduced image of the circuit pattern within the illumination area of reticle R (a partial reduced image of the circuit pattern) is formed on the wafer whose surface is coated with a resist (a photosensitive material) via projection unit PU (projection optical system PL) .

Further, although it is omitted in the drawings, among the plurality of lenses making up projection optical system PL, a plurality of specific lenses operate under the control of an image forming quality correction controller 381 (refer to FIG. 7) based on instructions from main controller 20, so that optical properties (including image forming quality) of projection optical system PL such as magnification, distortion, coma, and curvature of field (including inclination of field) and the like can be adjusted.

In exposure apparatus 100 of the embodiment, because exposure to which the immersion method is applied is performed as in the description later on, the numerical aperture NA substantially increases which makes the opening on the reticle side larger. Therefore, in a dioptric system consisting only of lenses, it becomes difficult to satisfy the Petzval condition, which tends to lead to an increase in the size of the projection optical system. In order to prevent such an increase in the size of the projection optical system, a catadioptric system that includes mirrors and lenses may also be used.

Further, in exposure apparatus 100 of the embodiment, because exposure is performed applying the immersion method, a liquid supply nozzle 51A and a liquid recovery nozzle 51B that make up an immersion unit 132 are arranged in the vicinity of a lens 91, which serves as an optical element (hereinafter also referred to as a 'tip lens') that constitutes projection optical system PL closest to the image plane side (the wafer W side).

Liquid supply nozzle 51A connects to the other end of a supply pipe (not shown) that has one end connected to a liquid supply unit 288 (not shown in FIG. 1, refer to FIG. 7), and liquid recovery nozzle 51B connects to the other end of a recovery pipe (not shown) that has one end connected to a liquid recovery unit 292 (not shown in FIG. 1, refer to FIG. 7).

Liquid supply unit 288 includes parts such as a liquid tank, a pressure pump, and temperature control unit, and a valve for controlling the supply/stop of liquid with respect to the supply pipe and the like. As the valve, a flow control valve is preferably used, for example, so that not only the supply/stop of liquid but also the flow adjustment can be performed. The temperature control unit adjusts the temperature of the liquid inside the liquid tank so that is about the same temperature as the temperature within the chamber (not shown) where the main body of the exposure apparatus is housed.

Liquid recovery unit 292 consists of parts including a liquid tank and a suction pump, and a valve for controlling the supply/stop of liquid via the recovery pipe and the like. As the valve, a flow control valve is preferably used corresponding to the valve used in the liquid supply unit 288.

As the liquid referred to above, ultra pure water (hereinafter, ultra pure water will simply be referred to as 'water' besides the case when specifying is necessary) that transmits the ArF excimer laser beam (light with a wavelength of 193 nm) is to be used. Ultra pure water can be obtained in large quantities at a semiconductor manufacturing plant or the like, and it also has an advantage of having no adverse effect on the photoresist on the wafer or to the optical lenses.

Refractive index n of the water to the ArF excimer laser beam is said to be approximately 1.44. In the water the wavelength of illumination light IL is 193 nm x 1/n, shorted to around 134 nm.

Liquid supply unit 288 and liquid recovery unit 292 both have a controller, and the controllers operate under the control of main controller 20 (refer to FIG. 7). According to instructions from main controller 20, the controller of liquid supply unit 288 opens the valve connected to the supply pipe to a predetermined degree so as to supply the water in the space between tip lens 91 and wafer W via liquid supply nozzle 51A. Further, when the water is supplied, according to instructions from main controller 20, the controller of liquid recovery unit 292 opens the valve connected to the recovery pipe to a predetermined degree so that the water is recovered into liquid recovery unit 292 from the space between tip lens 91 and wafer W via recovery nozzle 51B. During the supply and recovery operations, main controller 20 gives orders to liquid supply unit 288 and liquid recovery unit 292 so that the amount of water supplied to the space between tip lens 91 and wafer W from liquid supply nozzle 51A constantly equals the amount of water recovered via liquid recovery nozzle 51B. Accordingly, a constant amount of water Lq (refer to FIG. 1) is held in the space between tip lens 91 and wafer W. In this case, water Lq held or retained in the space between tip lens 91 and wafer W is constantly replaced.

As is obvious from the description above, immersion unit 132 of the embodiment is a local immersion unit made up of parts including liquid supply unit 288, liquid recovery unit 292, the supply pipe, the recovery pipe, liquid supply nozzle 51A and liquid recovery nozzle 51B and the like.

In the case measurement stage MST is positioned below projection unit PU, it is possible to fill in the space between measurement table MTB and tip lens 91 with the water as is described above.

In the description above, only one liquid supply nozzle and one liquid recovery nozzle were arranged in order to simplify the description, however, the present invention is not limited to this, and a configuration that has many nozzles as is disclosed in, for example, the pamphlet of International Publication No. WO99/49504 can be employed. The point is that any configuration can be employed as long as the liquid can be supplied in the space between optical element (tip lens) 91 that constitutes projection optical system PL at the lowest end and wafer W.

Although it is not shown in the drawings, on the outer side of the immersion area where water Lq is held such as, for example, the outer side of liquid supply nozzle 51A and liquid recovery nozzle 51B, a leakage sensor by the optical fiber method is installed, and based on the output of the leakage sensor, main controller 20 can detect leakage immediately when leakage occurs.

Stage unit 50 is equipped with a frame caster FC, a base platform 12 arranged on frame caster FC, wafer stage WST and measurement stage MST arranged above the upper surface of base platform 12, an interferometer system 118 (refer to FIG. 7) that includes interferometers 16 and 18 for measuring the positions of stage WST and stage MST, and a stage drive system 124 (refer to FIG.7) for driving stages WST and MST.

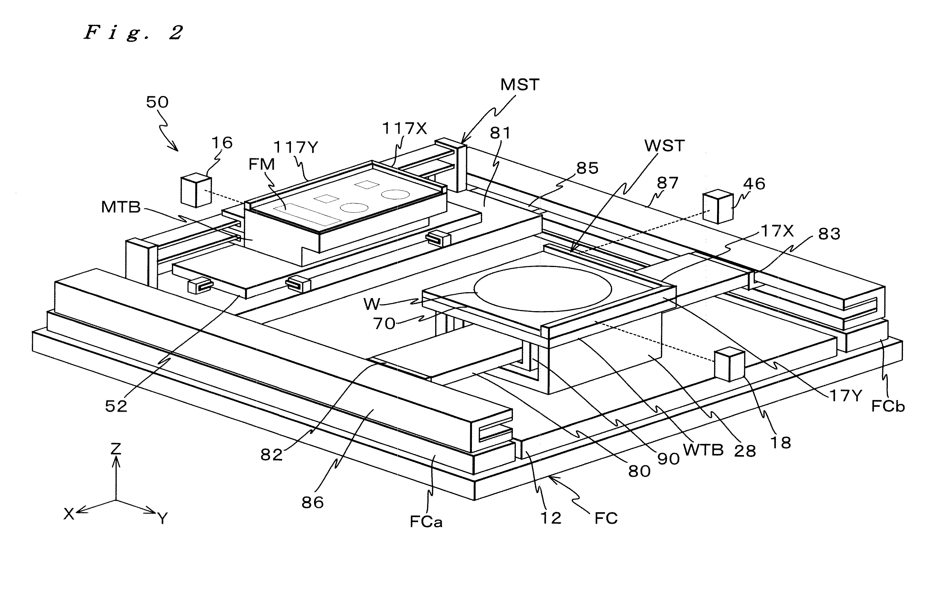

As is obvious from FIG. 2, which shows a perspective view of stage unit 150, frame caster FC is composed of a roughly plate-shaped member, on which protruding sections FCa and FCb whose longitudinal direction is in the Y-axis direction are integrally formed in the vicinity of the edge sections on both sides in the X-axis direction.

Base platform 12 is composed of a plate-shaped member, which is also referred to as a surface table, and is arranged on an area between protruding sections FCa and FCb of frame caster FC. The degree of flatness of the upper surface of base platform 12 is extremely high, and the upper surface serves as a guide surface when wafer stage WST and measurement stage MST moves.

As is shown in FIG. 2, wafer stage WST is equipped with a wafer stage main body 28 arranged above base platform 12, and a wafer table WTB mounted on wafer stage main body 28 via a Z-tilt drive mechanism (not shown). Z-tilt drive mechanism actually includes three actuators (e.g. voice coil motors or electromagnets) or the like that support wafer table WTB at three points on wafer stage main body 28, and Z-tilt drive mechanism finely drives wafer table WTB in directions of three degrees of freedom, in the Z-axis direction, a θx direction (a rotation direction around the X-axis), and a θy direction (a rotation direction around the Y-axis).

Wafer stage main body 28 is composed of a hollow member extending in the X-axis direction that has a rectangular framed sectional shape. On the lower surface of wafer stage main body 28, a plurality of (e.g. four) static gas bearings (not shown) such as air bearings is arranged, and wafer stage WST is supported in a non-contact manner via the bearings, via a clearance of around several µm above the guide surface previously described.

As is shown in FIG. 2, above protruding section FCa of frame caster FC, a Y-axis stator 86 is installed, extending in the Y-axis direction. Similarly, above protruding section FCb of frame caster FC, a Y-axis stator 87 is installed, extending in the Y-axis direction. Y-axis stators 86 and 87 are supported by levitation by static gas bearings (not shown) such as air bearings arranged on the lower surface of the stators, via a predetermined clearance with respect to the upper surface of protruding sections FCa and FCb. In the embodiment, Y-axis stators 86 and 87 are each configured of a magnetic pole unit, which is made up of a plurality of permanent magnet groups.

Inside wafer stage main body 28, a magnetic pole unit 90 is arranged that has a plurality of permanent magnets, serving as a mover in the X -axis direction.

In the space inside magnetic pole unit 90, an X-axis stator 80 extending in the X-axis direction is inserted. X-axis stator 80 is configured by an armature unit that incorporates a plurality of armature coils installed along the X-axis direction at a predetermined distance. In this case, magnetic pole unit 90 and X-axis stator 80 consisting of the armature unit constitute a moving magnet type X-axis linear motor that drives wafer stage WST in the X-axis direction. Hereinafter, the X-axis linear motor will be appropriately referred to as an X-axis linear motor 80, using the same reference numeral as its stator (the stator for the X-axis), X-axis stator 80. Instead of the moving magnet type linear motor, a moving coil type linear motor may also be used as the X-axis linear motor.

On both ends of X-axis stator 80 in the longitudinal direction, for example, movers 82 and 83 consisting of armature units incorporated with a plurality of armature coils installed along the Y-axis direction at a predetermined distance are respectively fixed. Movers 82 and 83 are each inserted into Y-axis stators 86 and 87 from the inside. That is, in the embodiment, movers 82 and 83 consisting of the armature units and Y-axis stators 86 and 87 consisting of the magnetic pole units constitute two Y-axis linear motors of a moving coil type. Hereinafter, the two Y-axis linear motors will be appropriately referred to as Y-axis linear motor 82 and Y-axis linear motor 83, using the same reference numerals as the movers, Y-axis movers 82 and 83. As Y-axis linear motors 82 and 83, linear motors of the moving magnet type may also be used.

That is, wafer stage WST is driven in the X-axis direction by X-axis liner motor 80, and is also driven in the Y-axis direction integrally with X-axis linear motor 80 by the pair of Y-axis linear motors 82 and 83. In addition, by slightly changing the drive force in the Y-axis direction generated by Y-axis linear motors 82 and 83, wafer stage WST can also be rotationally driven in the θz direction.

On wafer table WTB, a wafer holder 70 that holds wafer W is arranged. Wafer holder 70 is equipped with a plate-shaped main body section, and an auxiliary plate fixed on the upper surface of the main body section that has a circular opening formed in the center whose diameter is larger by around 2 mm than the diameter of wafer W. A large number of pins are arranged in the area of the main body section within the circular opening of the auxiliary plate, and wafer W is vacuum suctioned in a state where wafer W is supported by the large number of pins. In this case, in the state where wafer W is vacuum suctioned, the height of the surface of wafer W and the surface of the auxiliary plate is to be substantially flush.

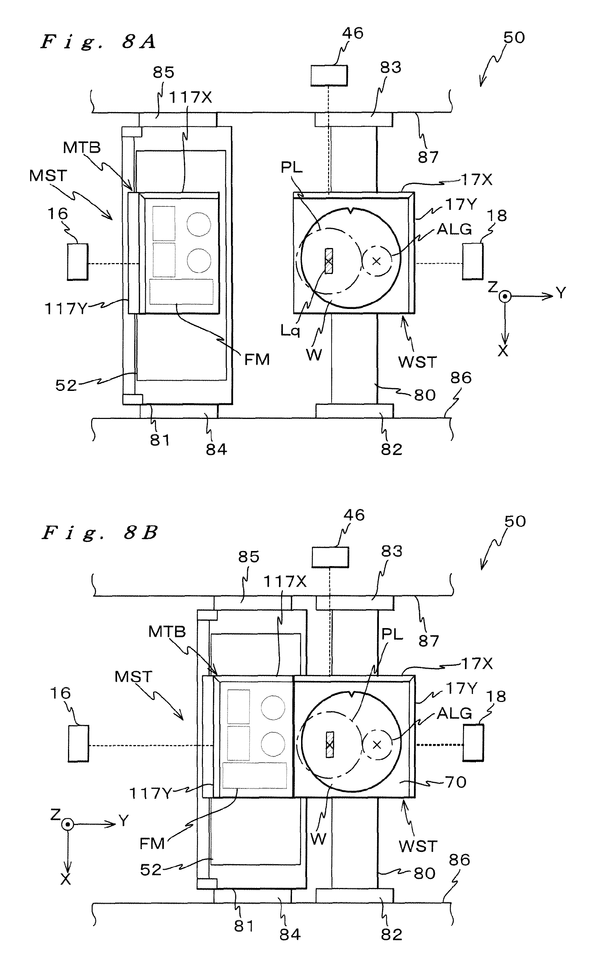

Further, on the upper surface of wafer table WTB, as is shown in FIG. 2, an X movable mirror 17X that has a reflection surface orthogonal to the X-axis on one end in the X-axis direction (the -X side end) is arranged extending in the Y-axis direction, and a Y movable mirror 17Y that has a reflection surface orthogonal to the Y-axis on one end in the Y-axis direction (the +Y side end) is arranged extending in the X-axis direction. As is shown in FIG. 2, interferometer beams (measurement beams) from an X-axis interferometer 46 and a Y-axis interferometer 18 that configure interferometer system 118 (to be described later, refer to FIG. 7) are projected on each reflection surface of movable mirrors 17X and 17Y, and by each of the interferometers 46 and 18 receiving the reflection beams, displacement of the reflection surface of each movable mirror from the reference position (normally, a fixed mirror is arranged on the side surface of projection unit PU or on the side surface of an off-axis alignment system ALG (refer to FIGS. 7 and 8A), which is to be the reference plane) is measured. Y-axis interferometer 18 has a measurement axis which is parallel to the Y-axis and joins the detection center of projection optical system PL (optical axis AX) and the detection center of alignment system ALG, whereas X-axis interferometer 46 has a measurement axis which perpendicularly intersects with the measurement axis of Y-axis interferometer 18 at the projection center of projection optical system PL (refer to FIG. 8A and the like).

Y-axis interferometer 18 is a multi-axis interferometer that has at least three optical axes, and the output values of each optical axis can be independently measured. The output values (measurement values) of Y-axis interferometer 18 are supplied to main controller 20 as is shown in FIG. 7, and based on the output values of Y-axis interferometer 18, main controller 20 can measure not only the position of wafer table WTB in the Y-axis direction (Y position) but also the rotation amount around the X-axis (pitching amount) and the rotation amount around the Z-axis (yawing amount). Further, X-axis interferometer 46 is a multi-axis interferometer that has at least two optical axes, and the output values of each optical axis can be independently measured. The output values (measurement values) of X-axis interferometer 46 are supplied to main controller 20, and based on the output values of X-axis interferometer 46, main controller 20 can measure not only the position of wafer table WTB in the X-axis direction (X position) but also the rotation amount around the Y-axis (rolling amount).

As is described above, on wafer table WTB, movable mirror 17X and movable mirror 17Y are actually arranged, however, the mirrors are representatively shown as movable mirror 17 in FIG. 1. The edge surface of wafer table WTB can also be mirror-polished, for example, in order to form a reflection surface (corresponding to the reflection surface of movable mirrors 17X and 17Y).

As is shown in FIG. 2, measurement stage MST is configured by combining a plurality of members such as a Y stage 81 whose longitudinal direction is the X-axis direction or the like, and measurement stage MST is supported in a non-contact manner via a plurality of static gas bearings such as air bearings which are arranged on the lowest surface of measurement stage MST (the lower surface of the member closest to base platform 12), via a clearance of around several µm above the upper surface (guide surface) of base platform 12.

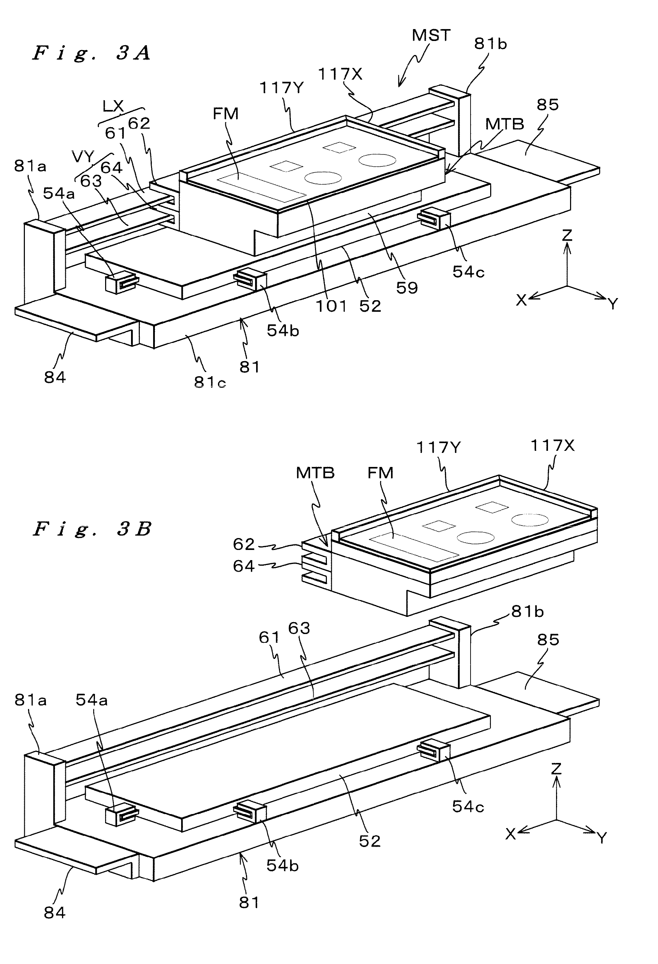

As it is obvious from the perspective view of FIG. 3A, measurement stage MST is equipped with a rectangular plate-shaped measurement stage main body 81c narrowly extending in the X-axis direction, Y stage 81 that has a pair of protruding sections 81a and 81b each fixed on the upper surface of measurement stage main body 81c on both sides of the X-axis direction, a leveling table 52 installed above the upper surface of measurement stage main body 81c, and a measurement table MTB which constitutes at least part of a measurement unit arranged on leveling table 52.

On the end surface of both one end and the other end of measurement stage main body 81c, which constitutes part of Y stage 81, in the X-axis direction, movers 84 and 85 consisting of armature units that incorporate a plurality of armature coils arranged along the Y-axis direction at a predetermined distance are respectively fixed. Movers 84 and 85 are inserted inside Y-axis stators 86 and 87, respectively. That is, in the embodiment, movers 84 and 85 consisting of armature units and Y-axis stators 86 and 87 consisting of magnetic pole units in which movers 84 and 85 are respectively inserted constitute two moving coil type Y-axis linear motors. Hereinafter, the two Y-axis linear motors described above will be appropriately referred to as Y-axis linear motor 84 and Y-axis linear motor 85, using the same reference numerals as the movers 84 and 85. In the embodiment, Y-axis linear motors 84 and 85 drive the entire measurement stage MST in the Y-axis direction. As the Y-axis linear motors 82 and 83, linear motors of the moving magnet type may also be used.

On the bottom surface of measurement stage main body 81c, the plurality of static gas bearings is arranged. On the upper surface of measurement stage main body 81c on both one side and the other side in the X-axis direction on the edge near the -Y side, the pair of protruding sections 81a and 81b is fixed facing each other. In between protruding sections 81a and 81b, stators 61 and 63 each extending in the X-axis direction are installed in the Z-axis direction (vertically) at a predetermined distance, and both ends of stators 61 and 63 are respectively fixed to protruding sections 81a and 81b.

On the end surface of leveling table 52 on the +X side, a mover of an X voice coil motor 54a is arranged, and the stator of X voice coil motor 54a is fixed to the upper surface of measurement stage main body 81c. Further, on the end surface of leveling table 52 on the +Y side, movers of Y voice coil motors 54b and 54c are respectively arranged, and the stators of Y voice coil motors 54b and 54c are fixed to the upper surface of measurement stage main body 81c. X voice coil motor 54a is configured of, for example, a mover composed of a magnetic pole unit and a stator composed of an armature unit, and a drive force in the X-axis direction is generated by an electromagnetic interaction between the mover and the stator. In addition, Y voice coil motors 54b and 54c are also similarly configured, and a drive force in the Y-axis direction is generated. That is, leveling table 52 is driven in the X-axis direction with respect to Y stage 81 by X voice coil motor 54a, as well as in the Y-axis direction with respect to Y stage 81 by Y voice coil motors 54b and 54c. in addition, by changing the drive force generated by Y voice coil motors 54b and 54c, leveling table 52 can also be rotationally driven around the Z-axis (the θz direction) with respect to Y stage 81.

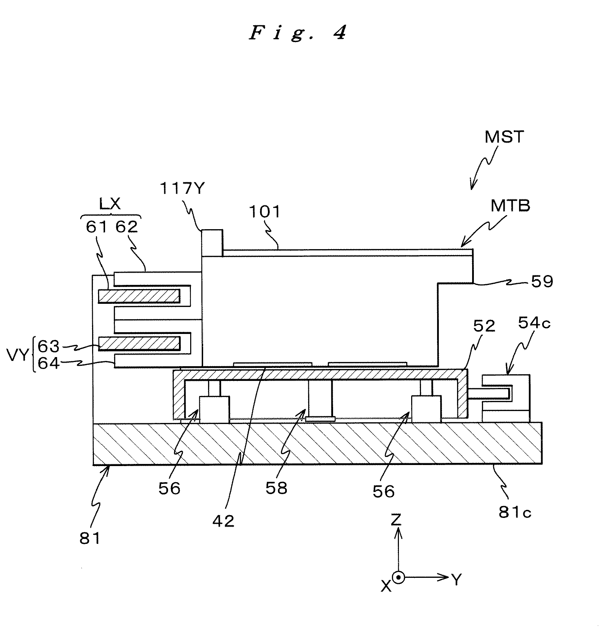

As is modeled partially sectioned in FIG. 4, leveling table 52 consists of a housing that has a plate shape when viewed from the outside and also has an opening formed on the bottom surface, and inside the housing, three Z voice coil motors 56 (however, Z voice coil motor 56 in the depth of the page surface is not shown) that generate a drive force in the Z-axis direction are installed. The stator of each of the Z voice coil motors 56 consists of an armature unit and is fixed on the upper surface of measurement stage main body 81c. Further, the mover of each of the Z voice coil motors 56 consists of a magnetic pole unit and is fixed to leveling table 52. These three Z voice coil motors 56 generate a drive force in the Z-axis direction due to the electromagnetic interaction between each stator and mover. Accordingly, leveling table 52 is driven in the Z-axis direction by the three Z voice coil motors 56, and also driven finely in the rotation direction around the X-axis (the θx direction) and the rotation direction around the Y-axis (the θy direction).

That is, leveling table 52 is finely drivable in a non-contact manner in directions of six degrees of freedom (in the X, Y, Z, θx, θy, and θz directions) by X voice coil motor 54a, Y voice coil motors 54b and 54c, and the three Z voice coil motors 56.

Further, as is shown in FIG. 4, inside leveling table 52, a self-weight cancel mechanism 58 that cancels the weight of leveling table 52 is also installed. That is, it can also be said that self-weight cancel mechanism 58 compensates for the weight of measurement table MTB. Self-weight cancel mechanism 58 is installed in the vicinity of the rough centroid of the triangle formed by the three Z voice coil motors 56 previously described.

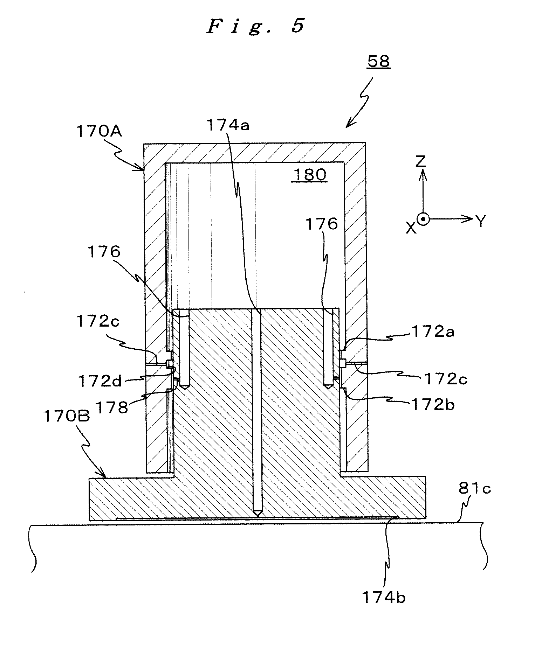

As is shown in the longitudinal sectional view of FIG. 5, self-weight canceller 58 has an opening in the lower end section (the end on the -Z side), and is equipped with a cylinder section 170A of a cylindrical shape whose upper end section (the end on the +Z side) is closed, and a piston section 170B that is inserted into the inside of cylinder section 170A via the opening and can move relatively with respect to cylinder section 170A.

In the vicinity of the lower end section (the end on the -Z side) of cylinder section 170A along the whole circumference on the inner circumference surface, a first annular projecting section 172a that has a ring-like shape is formed. Further, on the side lower than the first annular projecting section 172a (the -Z side), a second annular projecting section 172b is formed spaced a predetermined distance apart. And, on the inner bottom surface of an annular recessed groove 172d that has a predetermined depth and is between the first annular projecting section 172a and the second annular projecting section 172b of cylinder section 170A, through holes 172c that communicate the inner space of cylinder section 170A with the outside are formed in a plurality of places at a predetermined spacing.

Piston section 170B is inserted into cylinder section 170A in a state where a predetermined clearance is formed between its outer circumference surface and the first and second annular projecting sections 172a and 172b.

Piston section 170B has a cylindrical column shape consisting of two stepped sections; a cylindrical column section with a first diameter, and a circular plate section with a second diameter (larger than the first diameter) arranged on the -Z side of the cylindrical column section and concentric with the cylindrical column section. In piston section 170B, a vent line 174a is formed in the Z-axis direction, from the center of the upper end surface all the way down to the bottom surface. Vent line 174a communicates with a groove 174b formed on the lower end surface of piston section 170B (the end surface on the -Z side), and is processed so that the line becomes narrower the closer it becomes to the lower end surface of 170B. That is, the lower end section of vent line 174a is made so as to function as a kind of a nozzle (tapered nozzle). Groove 174b actually has a combined shape of a circle and a cross, which crisscrosses at the center of the circle.

Further, in the vicinity of the periphery of the upper end surface of piston section 170B, four vent lines 176 (however, only two vent lines 176 respectively located on the +Y side and the -Y side are shown in FIG. 5, and the remaining two vent lines 176 respectively located on the +X side and the -X side are not shown) are formed spaced apart at a center angle of 90 degrees in a state where the vent lines are dug down to the position slightly above the center section in the height direction of piston section 170B. In the vicinity of the lower end section of these four vent lines 176, an aperture opening 178 serving as a gas blowout that connects with the outer circumferential surface of 170B on the outside is formed in a penetrating manner.

In this case, a space 180 of a substantially sealed state is formed inside cylinder section 170A above piston section 170B. One end of a gas supply pipe (not shown) connects to space 180 via an opening (not shown) formed in a part of cylinder section 170A, and the other end of the gas supply pipe connects to a gas supply unit (not shown). From the gas supply unit, gas such as, for example, gas such as rare gas as in helium, or nitrogen, or air is supplied into space 180 via the gas supply pipe, so as to make space 180 into a positive pressure space whose barometric pressure is higher than that of the outside of cylinder 170A. Accordingly, hereinafter, space 180 will also be referred to as "positive pressure space 180".

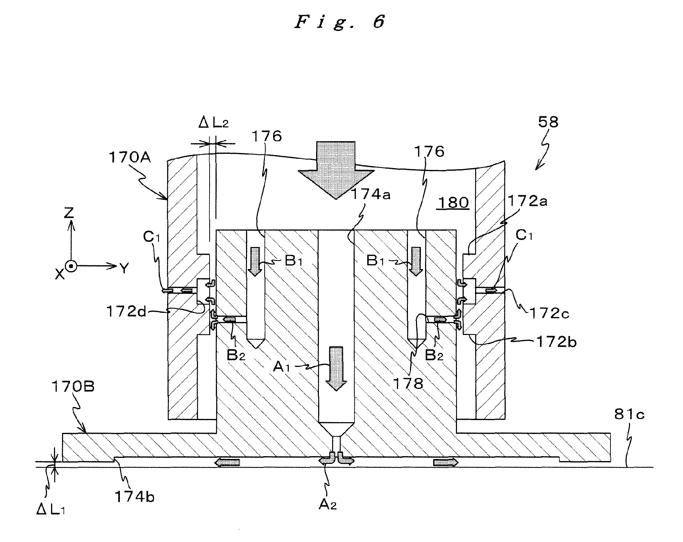

As is shown in FIG. 6, in self-weight canceller 58 that has the structure described above, because space 180 is a positive pressure space a gas flow indicated by an arrow A₁ (hereinafter also referred to as "flow A₁") occurs within vent line 174a. The gas shown as flow A₁ blows out from the tapered nozzle section at the lower end of vent line 174a, which generates a flow indicated by an arrow A₂ in groove 174b. This gas spreads in the entire area of groove 174b, and the gas blows out entirely from groove 174b toward the upper surface of measurement stage main body 81c. By the gas that blows out, static pressure (gap pressure) of the gas occurs between the bottom surface of piston section 170B and the upper surface of measurement stage main body 81c, which forms a predetermined clearance ΔL₁ between the bottom surface of piston section 170B and the upper surface of measurement stage main body 81c. That is, a kind of a static gas bearing is substantially formed on the bottom surface of piston section 170B, and piston section 170B is supported above measurement stage main body 81c by levitation in a non-contact manner. Hereinafter the static gas bearing will also be referred to as a "thrust bearing".

Similar to vent line 174a, a gas flow indicated by an arrow B₁ occurs within each of the four vent lines 176, and with the gas flow, a gas flow indicated by an arrow B₂ that flows from inside piston section 170B to the outside occurs in aperture opening 178 which blows against the second annular projecting section 172b. In this case, by static pressure (gap pressure) of the gas between the second annular projecting section 172b and the outer circumferential surface of piston section 170B, a predetermined clearance ΔL₂ is formed between the second annular projecting section 172b and the outer circumferential surface of piston section 170B. That is, a kind of a static gas bearing is substantially formed in the peripheral wall of piston section 170B, and piston section 170B and cylinder section 170A do not come into contact. Hereinafter the static gas bearing will also be referred to as a "radial bearing".

Furthermore, in the plurality of through holes 172c that are formed at a predetermined spacing in annular recessed groove 172d of cylinder section 170A, a gas flow indicated by an arrow C₁ occurs, and by the flow, the gas within clearance ΔL₂ such as the gas that blows out against the second annular projecting section 172b, the gas within positive pressure space 180 and the like are exhausted outside.

According to self-weight canceller 58 of the embodiment, when self-weight canceller 58 supports leveling table 52 with the upper end section, the weight of leveling table 52 is supported by the positive pressure of positive pressure space 180, and in the space made with the upper surface of measurement stage main body 81c that constitutes Y stage 81, clearance ΔL₁ can constantly be maintained by the action of the strut bearing. Further, in the case a force that makes leveling table 52 tilt toward the direction of inclination (the θx direction and the θy direction) occurs in leveling table 52, self-weight canceller 58 tries to maintain clearance ΔL₂ by the action of the radial bearing, which absorbs the inclination of leveling table 52. Accordingly, with self-weight canceller 58, leveling table 52 can be supported by positive pressure with low rigidity, and the inclination can also be absorbed.

Referring back to FIG. 3A, measurement table MTB is equipped with a measurement table main body 59 constituted of materials such as Zerodur (brand name of Schott Corporation), and movers 62 and 64 shaped roughly in the letter U whose longitudinal direction is the X-axis direction that are fixed vertically on the -Y side of measurement table main body 59.

On the bottom surface of measurement table main body 59, a plurality of, e.g. four, air bearings 42 (refer to FIG. 4) are arranged, and via air bearings 42, measurement table MTB is supported by levitation in a non-contact manner above the upper surface of leveling table 52 via a clearance of around several µ m.

Mover 62 is equipped with a mover yoke whose YZ sectional surface is a rough U-shape, and a permanent magnet group consisting of a plurality of N-pole permanent magnets and S-pole permanent magnets that are arranged alternately at a predetermined spacing along the X-axis direction on the inner surface of the mover yoke (the upper and lower surface), and is in a state engaged with stator 62. In the space inside the mover yoke of mover 62, an alternating magnetic field is formed along the X-axis direction. Stator 61, for example, is made up of an armature unit that incorporates a plurality of armature coils arranged along the X-axis direction at a predetermined spacing. That is, stator 61 and mover 62 constitute a moving magnet type X-axis linear motor LX.

Mover 64 is equipped with a mover yoke whose YZ sectional surface is a rough U-shape, and a permanent magnet group consisting of a plurality of N-pole permanent magnets and S-pole permanent magnets that are arranged alternately at a predetermined spacing along the X-axis direction on the inner surface of the mover yoke (the upper and lower surface), and is in a state engaged with stator 63. Stator 63 is equipped with an armature coil that is arranged inside the stator in an arrangement so that the current only flows in the X-axis direction in the magnetic field formed by the N-pole magnets and S-pole magnets. That is, mover 64 and stator 63 constitute a moving magnet type Y voice coil motor VY that drives measurement table MTB in the Y-axis direction.

As is obvious from the description so far, in the embodiment, Y-axis liner motors 82 to 85 and X-axis linear motor 80, a fine drive mechanism (not shown) that drives wafer table WTB, and each of the motors described above (54a to 54c, 56, LX, and VY) on measurement stage MST constitute stage drive section 124 shown in FIG. 7. And, various drive mechanisms that make up stage drive section 124 are made to operate under the control of main controller 20 shown in FIG. 7.

Measurement table MTB is further equipped with measurement instruments for performing various measurements related to exposure. More specifically, on the upper surface of measurement table main body 59, a plate 101 is arranged made of a glass material such as Zerodur (brand name of Schott Corporation), silica glass or the like. On the surface of plate 101, chromium is coated on substantially the entire surface, and in some areas, an area for measurement instruments and a fiducial mark area FM in which a plurality of fiducial marks are formed as is disclosed in, for example, Kokai (Japanese Unexamined Patent Application Publication) No. 05-21314 and the corresponding U.S. Patent No. 5, 243, 195 and the like, are arranged. As long as the national laws in designated states (or elected states), to which this international application is applied, permit, the above disclosures of the publication and the corresponding U.S. Patent are incorporated herein by reference.

In the area for the measurement instruments, patterning is applied and aperture patterns for various types of measurement are formed. As the aperture patterns for measurement, for example, patterns such as an aperture pattern used for aerial image measurement (e.g., a slit-shaped aperture pattern), a pinhole aperture pattern used for irregular illumination measurement, an aperture pattern used for illuminance measurement, an aperture pattern used for wavefront aberration measurement and the like are formed.

Inside measurement table main body 59 under the aperture pattern used for aerial image measurement, a light-receiving system is arranged, which receives the exposure light via the aerial image measurement pattern, irradiated on plate 101 via projection optical system PL and the water. The light-receiving system constitutes an aerial image measurement instrument, which measures the light intensity of an aerial image (projected image) of a pattern projected by projection optical system PL. The details of the instrument are disclosed in, for example, Kokai (Japanese Unexamined Patent Application Publication) No. 2002-14005 and the corresponding U.S. Patent Application Publication No. 2002/0041377 Description.

Further, inside measurement table main body 59 under the pinhole aperture pattern used for irregular illumination measurement, a light-receiving system that includes a light-receiving element is arranged. The light-receiving system including the light-receiving element constitutes an irregular illuminance measurement instrument, which has a pinhole-shaped light-receiving section that receives illumination light IL on the image plane of projection optical system PL. The details of the instrument are disclosed in, for example, Kokai (Japanese Unexamined Patent Application Publication) No. 57-117238 and the corresponding U.S. Patent Publication No. 4,465,368 Description.

Further, inside measurement table main body 59 under the aperture pattern used for illuminance measurement, a light-receiving system that includes a light-receiving element is arranged. The light-receiving system including the light-receiving element constitutes an illuminance monitor, which has a light-receiving section of a predetermined area that receives illumination light IL on the image plane of projection optical system PL via the water. The details of the instrument are disclosed in, for example, Kokai (Japanese Unexamined Patent Application Publication) No. 11-16816 and the corresponding U.S. Patent Application Publication No. 2002/0061469 Description. As long as the national laws in designated states (or elected states), to which this international application is applied, permit, the above disclosures of the publication and the U.S. Patent Application Description are incorporated herein by reference.

Further, inside measurement table main body 59 under the aperture pattern used for wavefront aberration measurement, for example, a light-receiving system that includes a microlens array is arranged. The light-receiving system including the microlens array constitutes a wavefront aberration measurement instrument. The details of the instrument are disclosed in, for example, the pamphlet of International Publication Number WO99/60361, and the corresponding European Patent Publication No. 1,079,223 Description.

In FIG. 7, the aerial image measurement instrument, the irregular illumination measurement instrument, the illuminance monitor, and the wavefront aberration measurement instrument are shown as measurement instrument group 43.

In the embodiment, in response to the immersion exposure where wafer W is exposed by exposure light (illumination light) IL via projection optical system PL and the water, the instruments used for measurement as in the illuminance monitor, the irregular illumination measurement instrument, the aerial image measurement instrument, and the wavefront aberration measurement instrument described above that use illumination light IL will receive illumination light IL via projection optical system PL and the water. Therefore, a water-repellent coating may be performed on the surface of plate 101. In addition, in each of the measurement instruments described above, only a part of each measurement instrument, such as the optical system, may be built in measurement stage MST, or the whole instrument may be installed in measurement stage MST.

On the upper surface of measurement table MTB (plate 101), on one end (the end on the -X side) in the X-axis direction, an X movable mirror 117X that has a reflection surface orthogonal to the X-axis is arranged extending in the Y-axis direction, and on one end (the end on the -Y side) in the Y-axis direction, a Y movable mirror 117Y that has a reflection surface orthogonal to the Y-axis is arranged extending in the X-axis direction. As is shown in FIG. 2, the interferometer beam (measurement beam) from Y-axis interferometer 16 that constitutes interferometer system 118 is projected on the reflection surface of Y movable mirror 117Y, and by receiving the reflection beams interferometer 16 measures the displacement of the reflection surface of Y movable mirror 117Y from a reference position. Further, in the case measurement table MTB moves to the position directly under projection unit PU such as when measurement is performed, the interferometer beam (measurement beam) from X-axis interferometer 46 is projected on the reflection surface of X movable mirror 117X, and by receiving the reflection beams interferometer 46 measures the displacement of the reflection surface of X movable mirror 117X from a reference position. Y-axis interferometer 16 has a measurement axis, which is parallel to the Y-axis direction and perpendicularly intersects with the length measurement axis of X-axis interferometer 46 previously described at the projection center of projection optical system PL (optical axis AX).

Y-axis interferometer 16 is a multi-axis interferometer that has at least three optical axes, and the output values of each optical axis can be independently measured. The output values (measurement values) of Y-axis interferometer 16 are sent to main controller 20 as is shown in FIG. 7, and based on the output values from Y-axis interferometer 16, main controller 20 can measure not only the Y position of measurement table MTB but also the pitching amount and the yawing amount. Further, based on the output values from X-axis interferometer 46, main controller 20 measures the X position and the rolling amount of measurement table MTB.

As is obvious from the description so far, in the embodiment, the interferometer beams from Y-axis interferometer 18 is constantly projected on movable mirror 17Y in the entire movement area of wafer stage WST, whereas the interferometer beams from Y-axis interferometer 16 is constantly projected on movable mirror 117Y in the entire movement area of measurement stage MST. Accordingly, regarding the Y-axis direction, the position of stages WST and MST is constantly controlled based on the measurement values of Y-axis interferometers 18 and 16, by main controller 20.

Meanwhile, as it can be easily imagined from FIG. 2, main controller 20 controls the X position of wafer table WTB (wafer stage WST) based on the output values of X-axis interferometer 46 only in the range where the interferometer beams from X-axis interferometer 46 irradiates movable mirror 17X, and also controls the X position of measurement table MTB (measurement stage MST) based on the output values of X-axis interferometer 46 only in the range where the interferometer beams from X-axis interferometer 46 irradiates movable mirror 117X. Accordingly, the position of wafer table WTB and measurement table MTB while the X position cannot be controlled based on the output values of X-axis measurement interferometer 46 is measured with an encoder (not shown), and main controller 20 controls the position of wafer table WTB and measurement table MTB while the X position cannot be controlled based on the output values of X-axis measurement interferometer 46, based on the measurement values of the encoder.

Further, immediately after the point where the interferometer beams from X-axis interferometer 46 start irradiating movable mirror 17X or movable mirror 117X from the state where the interferometer beams do not irradiate either movable mirror 17X or movable mirror 117X, main controller 20 resets X-axis interferometer 46 that has not been used for control until this point, and hereinafter, main controller 20 controls the position or wafer stage WST or measurement stage MST using Y-axis interferometer 18 or 16 and X-axis interferometer 46 that constitute interferometer system 118.

In the embodiment, interferometer system 118 in FIG. 7 is configured including two Y-axis interferometers 16 and 18 and one X-axis interferometer 46. However, a configuration can be employed where a plurality of X-axis interferometers is arranged and interferometer beams from one of the X-axis interferometers constantly irradiate movable mirrors 17X and 117X. In this case, the X-axis interferometer that controls the position of wafer stage WST and measurement stage MST can be switched according to the X position of these stages.

Further, the multi-axis interferometer referred to earlier can be made to irradiate a laser beam on a reflection surface formed in a holding member where projection unit PU is held via a reflection surface formed in stages WST and MST at an inclination of 45 degrees, and detect relative position information related to the optical axis direction (the Z-axis direction) of projection optical system PL between the reflection surface and the stage.

Further, in exposure apparatus 100 of the embodiment, in the holding member that holds projection unit PU, an off-axis alignment system (hereinafter shortened to "alignment system") ALG (not shown in FIG. 1, refer to FIGS. 7, 8A and the like) is arranged. As this alignment system ALG, for example, a sensor of an FIA (Field image Alignment) system based on an image-processing method is used. This sensor irradiates a broadband detection beam that does not expose the resist on the wafer on a target mark, picks up the image of the target mark formed on the photodetection surface by the reflection light from the target mark and an index (not shown, an index pattern formed on an index plate arranged in alignment system ALG) with a pick-up device (such as a CCD), and outputs the imaging signals. The imaging signals from alignment system ALG are supplied to main controller 20 in FIG. 7.

As alignment system ALG, the sensor is not limited to the FIA system, and it is a matter of course that an alignment sensor that irradiates a coherent detection light on a target mark and detects the scattered light or diffracted light generated from the target mark, or a sensor that detects two diffracted lights (e.g. diffracted lights of the same order, or diffracted lights that diffract in the same direction) generated from the target mark by making them interfere with each other can be used independently, or appropriately combined.

In exposure apparatus 100 of the embodiment, although it is omitted in FIG. 1, a multiple point focal position detection system based on an oblique method constituted by an irradiation system 90a and a photodetection system 90b (refer to FIG. 7), similar to the one disclosed in, for example, Kokai (Japanese Patent Unexamined Application Publication) No. 6-283403 and the corresponding U.S. Patent No. 5,448,332, is arranged. In the embodiment, as an example, irradiation system 90a is supported by suspension on the -X side of projection unit PU by a holding member that holds projection unit PU, while photodetection system 90b is also supported by suspension under the holding member on the +X side of projection unit PU. That is, irradiation system 90a and photodetection system 90b, and projection optical system PL are attached to the same member, and the positional relation between the two is constantly maintained. As long as the national laws in designated states or elected states, to which this international application is applied, permit, the above disclosures of the publication and the U.S. Patent are incorporated herein by reference.

FIG. 7 shows the main configuration of a control system of exposure apparatus 100. The control system is mainly composed of main controller 20, which is made up of a microcomputer (or a workstation) that has overall control over the entire apparatus. Further, main controller 20 connects to a display DIS such as a memory MEM, a CRT display (or a liquid crystal display) or the like.

Next, details on a parallel processing operation using wafer stage WST and measurement stage MST in exposure apparatus 100 of the embodiment that has the arrangement described above will be described, referring to FIGS. 8A to 10. During the operation below, main controller 20 performs the open/close operation of each valve in liquid supply unit 288 and liquid recovery unit 292 of immersion unit 132, and the space directly under tip lens 91 of projection optical system PL is constantly filled with water. However, in the description below, for the sake of simplicity, the description related to the control of liquid supply unit 288 and liquid recovery unit 292 will be omitted.

FIG. 8A shows a state where exposure of wafer W (e.g. one lot, in this case (one lot is 25 or 50 wafers)) on wafer stage WST is performed by the step-and-scan method. At this point, measurement stage MST is waiting at a predetermined waiting position where it does not bump into wafer stage WST.

The exposure operation above is performed by repeating a movement operation between shots where wafer stage WST is moved to a scanning staring position (acceleration starting position) for exposure of each shot area on wafer W and a scanning exposure operation where the pattern formed on reticle R is transferred on each shot area by the scanning exposure method, based on results of wafer alignment such as Enhanced Global Alignment (EGA) performed by main controller 20 in advance and the latest baseline measurement results of alignment system ALG or the like.

Main controller 20 performs the movement operation between shots referred to above where wafer stage WST is moved by controlling X-axis linear motor 80 and Y-axis linear motors 82 and 83 while monitoring the measurement values of interferometers 18 and 46. Further, main controller 20 achieves the scanning exposure above by controlling reticle stage drive section 11 and Y-axis linear motors 82 and 83 (and X-axis linear motor 80) 83 while monitoring the measurement values of interferometers 18 and 46 and reticle interferometer 116 so that reticle R (reticle stage RST) and wafer W (wafer stage WST) are relatively scanned in the Y-axis direction, and by synchronously moving reticle R (reticle stage RST) and wafer W (wafer stage WST) at a constant speed in the Y-axis direction with respect to the illumination area of illumination light IL during the constant movement period in the relative scanning, which is after when the acceleration has been completed until just before the deceleration begins. The exposure operation described above is performed in a state where the water is held between tip lens 91 and wafer W.

Then, at the stage where exposure of wafer W has been completed on the wafer stage WST side, main controller 20 controls Y-axis linear motor 84 and 85 and X-axis linear motor LX based on the measurement values of interferometer 16 and the measurement values of the encoder (not shown), and moves measurement table MTB to the position shown in FIG. 8B. In the state shown in FIG. 8B, the edge surface of measurement table MTB on the +Y side is in contact with the edge surface of wafer table WTB on the -Y side. A non-contact state of measurement table MTB and wafer table WTB can also be maintained by monitoring the measurement values of interferometers 16 and 18, and separating measurement table MTB and wafer table WTB by around 300 µm in the Y-axis direction.

Next, main controller 20 begins an operation of simultaneously driving both stages WST and MST in the +Y direction while maintaining the positional relation of wafer table WTB and measurement table MTB in the Y-axis direction.

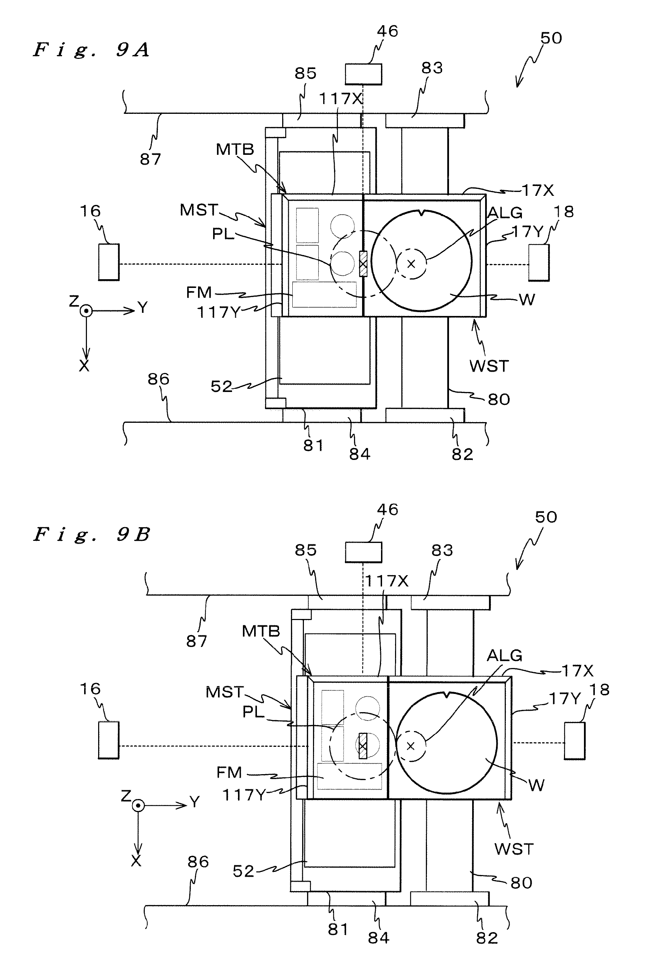

When wafer stage WST and measurement stage MST are simultaneously driven in the manner described above by main controller 20, in the state shown in FIG. 8B, the water held between tip lens 91 of projection unit PU and wafer W sequentially moves over the following areas with the movement of wafer stage WST and measurement stage MST to the +Y side: wafer W → wafer holder 70 → measurement table MTB. During the movement, wafer table WTB and measurement table MTB maintain the positional relation of being in contact. FIG. 9A shows a state where the water simultaneously exists on both wafer stage WST and measurement stage MST during the movement above, that is, the state just before the water is passed over from wafer stage WST to measurement stage MST.

When wafer stages WST and measurement stage MST are further driven simultaneously by a predetermined distance in the +Y direction from the state shown in FIG. 9A, then the water moves into a state where it is held in the space between measurement stage MST and tip lens 91 as is shown in FIG. 9B. And, prior to this state, main controller 20 resets X-axis interferometer 46 at some point where the interferometer beam from X-axis interferometer 46 begins to be irradiated on movable mirror 117X on measurement table MTB. Further, in the state shown in FIG. 9B, main controller controls the X position of wafer table WTB (wafer stage WST) based on the measurement values of the encoder (not shown).

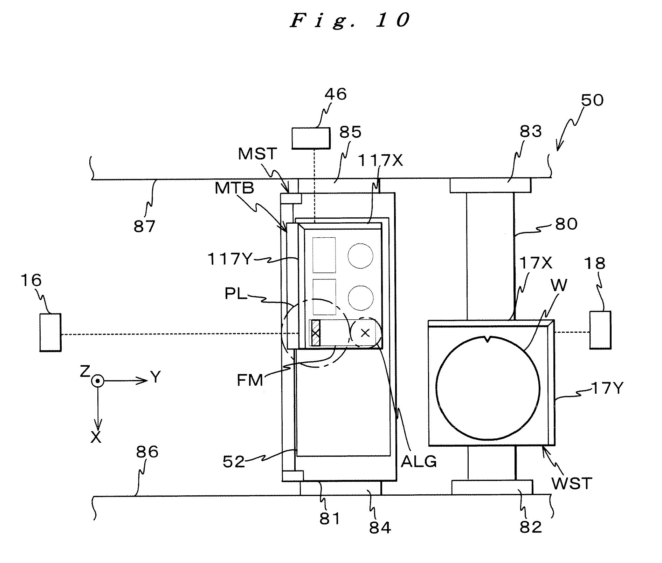

Next, main controller 20 moves wafer stage WST to a predetermined wafer exchange position by controlling linear motors 80, 82 and 83 while controlling the position of wafer stage WST based on the measurement values of interferometer 18 and the encoder, and also exchanges the wafer to the first wafer of the next lot, while performing predetermined measurements that use measurement stage MST in parallel as necessary. As such measurement, for example, baseline measurement of alignment system ALG, which is performed after the reticle has been exchanged on reticle stage RST, can be given. To be more specific, main controller 20 detects a first fiducial mark in pairs on a fiducial mark plate FM arranged on plate 101 on measurement table MTB and the corresponding reticle alignment marks on the reticle at the same time using reticle alignment systems RAa and RAb previously described, and detects the positional relation between the first fiducial mark in pairs and the corresponding reticle alignment marks. And, at the same time, by also detecting second fiducial marks on fiducial mark plate FM with alignment system ALG, main controller 20 detects the positional relation between the detection center of alignment system ALG and the second fiducial mark. Then, based on the positional relation between the first fiducial mark in pairs and the corresponding reticle alignment marks and the positional relation between the detection center of alignment system ALG and the second fiducial marks obtained above, and the known positional relation between the first fiducial mark in pairs and the second fiducial marks, main controller 20 obtains the distance between the projection center (projection position) of the reticle pattern by projection optical system PL and the detection center (detection position) of alignment system ALG, that is, obtains the baseline of alignment system ALG. FIG. 10 shows this state.

Reticle alignment marks have been formed in a plurality of pairs on the reticle, and corresponding to the retile alignment marks the first fiducial mark in a plurality of pairs have been formed on fiducial mark plate FM, and along with measuring the baseline of alignment system ALG described above, by measuring the relative position of at least two pairs of the first fiducial marks and the corresponding reticle alignment marks using reticle alignment systems RAa and RAb while stepping reticle stage RST and wafer stage WST in the Y-axis direction, the so-called reticle alignment is performed.

In this case, detection using reticle alignment systems RAa and RAb is performed via projection optical system PL and the water.

Then, at the point where the operations described above on both stages WST and MST have been completed, main controller 20 makes measurement table MTB come into contact with wafer table WTB (wafer stage WST), and then drives measurement table MTB and wafer table WTB within the XY plane while maintaining the state, and moves wafer stage WST back to the position directly under the projection unit. Also during this movement, main controller 20 executes the reset of X-axis interferometer 46 at some point where the interferometer beam from X-axis interferometer 46 begins to be irradiated on movable mirror 17X on wafer table WTB. Then, on the wafer stage WST side, wafer alignment, that is detection of alignment marks on the wafer that has been exchanged is performed by alignment system ALG, and position coordinates of a plurality of shot area on the wafer is computed. Measurement table MTB and wafer table WTB (wafer stage WST) can be in a non-contact state, as is previously described.

Then, opposite to the operation above, main controller 20 simultaneously drives both stages WST and MST in the -Y direction while maintaining the positional relation of wafer table WTB (wafer stage WST) and measurement table MTB in the Y-axis direction, and then withdraws measurement stage MST to a predetermined position after wafer stage WST (the wafer) moves to the position under projection optical system PL.

Then, main controller 20 performs the exposure operation by the step-and-scan method on a new wafer as in the description above, and sequentially transfers the reticle pattern onto the plurality of shot areas on the wafer.

In the description above, as the measurement operation, the case has been described where baseline measurement has been performed. The measurement, however, is not limited to this, and measurements such as illuminance measurement, irregular illuminance measurement, aerial image measurement, wavefront aberration measurement and the like can be performed using measurement instrument group 43 of measurement stage MST while each wafer is exchanged on the wafer stage WST side, and the measurement results can be reflected to the exposure of the wafer that will be performed after the measurement. To be more specific, for example, image forming quality correction controller 381 can perform adjustment of projection optical system PL based on the measurement results.

In this case, according to the time required for wafer exchange, different measurements can be performed each time the wafer is exchanged. Further, in the case a measurement cannot be completed at once during a wafer exchange, the measurement can be divided into segments and can be performed a plurality of times.

As is described above, measurements using the various measurement instruments are performed in a state where water is filled in the space on plate 101 of measurement table MTB, therefore, a water-repellent coating is applied to the surface (upper surface) of plate 101. However, the water-repellent coating provides poor protection against ultraviolet light and deterioration occurs in the case ultraviolet light is irradiated for a long period of time; therefore, maintenance (exchange) of the water-repellent section has to be performed at a predetermined frequency. Considering such a point, in exposure apparatus 100 of the embodiment, measurement table MTB is made to be in a state engaged with the other components of measurement stage MST in a non-contact manner. More specifically, by shifting measurement table MTB to the +Y side and releasing the engagement of the mover and stator of both X linear motor LX and Y voice coil motor VY, measurement table MTB can be easily detached from other components of measurement stage MST, as is shown in FIG. 3B. And, in the embodiment, measurement table MTB is to be exchanged with a new measurement table at a predetermined exchange timing.

As the period of exchanging measurement table MTB, from the viewpoint of favorably maintaining the measurement accuracy of the various measurement and reducing the downtime of the unit that accompanies the exchange of measurement table MTB as much as possible, it is desirable to perform the exchange just before the water-repellent coating deteriorates (just before the deterioration exceeds a predetermined permissible value).

Therefore, in the embodiment, by an experiment performed in advance, measurement values of the various measurement instruments just before the water-repellent coating deteriorates are obtained, based on a relation between the water-repellent deterioration and the change in measurement results of the various measurement instruments arranged in measurement table MTB, and border values of the measurement results of the various measurement instruments that are about to exceed permissible values are stored in memory MEM (refer to FIG. 7) as threshold values. And, while the apparatus is being used, in the case measurement is performed using measurement table MTB, main controller 20 judges whether or not the exchange timing has arrived by comparing the measurement results with the threshold values stored in memory MEM. And, when main controller 20 judges that the exchange timing has come, main controller 20 shows the notice on display DIS (refer to FIG. 7). Then, an operator stops the operation of exposure apparatus 100, and executes the exchange of measurement tale MTB manually. That is, in the embodiment, main controller 20 and memory MEM constitute a detection unit that detects the exchange timing of plate 101.

In the case the exposure apparatus is equipped with a robot used for exchanging measurement table MTB, it is possible to make main controller 20 show the exchange timing on display DIS. It is also possible to make main controller 20 stop the operation of the apparatus, carry measurement table MTB outside using the robot or the like, and carry in the new measurement table on measurement stage main body 81c.

Further, when detecting the period for exchanging measurement table MTB, the judgment of whether or not the exchange timing has come can be made, for example, by guiding light other than the exposure light that has the same wavelength as the exposure light (detection light) to the vicinity of projection unit PU using an optical fiber or the like, irradiating the detection light on plate 101 of measurement table MTB on a section other than the section used for various measurements for the same time as (or a slightly longer time than) the measurement time, measuring the illuminance (light quantity) or the like of the detection light on irradiation by an optical sensor arranged only for exchange timing detection, and computing the degree of deterioration based on the measurement results. Besides the operation above, the degree of deterioration can be predicted based on deterioration time obtained in advance such as by simulation, using a timer or the like. The point is, any method can be employed as long as the level of deterioration of the water-repellent coating can be sensed using a method of some kind, and the exchange timing can be detected.

As is described in detail above, according to exposure apparatus 100 of the embodiment, exposure apparatus 100 has a plate 101 on which water (liquid) is supplied, and on measurement stage MST where measurement related to exposure is performed via the projection optical system and the water, measurement table MTB including plate 101 can be exchanged. Therefore, even in the case where measurement related to exposure is repeatedly performed using measurement stage MST via projection optical system PL and the water, by exchanging measurement table MTB before the surface of plate 101 deteriorates due to being in contact with water, measurement related to exposure can be performed with high precision at all times, which makes it possible to maintain exposure with high precision.

Further, in the exposure apparatus of the embodiment, the period just before the measurement accuracy of the various measurement instruments arranged in measurement table MTB begins to deteriorate is obtained in advance by experiment or the like, and this period is set in advance as the exchange timing of measurement table MTB, and main controller 20 detects the coming of the period in the manner previously described. Therefore, by exchanging measurement table MTB according to the detection results, it becomes possible to exchange measurement table MTB during the optimum period, which is before the deterioration of the measurement accuracy of the various measurement instruments arranged in measurement table MTB. That is, the measurement accuracy of the measurements related to exposure performed by measurement table MTB can be maintained with high precision, and the exchange frequency of measurement table MTB can also be suppressed as much as possible. Accordingly, the exposure accuracy can be maintained with high precision over a long period of time, and it also becomes possible to effectively prevent a reduction in the apparatus operation efficiency caused by the increasing downtime that accompanies the measurement table exchange.

Further, according to exposure apparatus 100, by performing exposure with high resolution and a larger depth of focus than in the air by the immersion exposure, the pattern of reticle R can be transferred with good precision on the wafer, and for example, transfer of a fine pattern that has a device rule of around 70 to 100 nm can be achieved.

In the embodiment above, the case has been described where measurement stage MST is equipped with measurement table MTB that can be exchanged. The present invention, however, is not limited to this, and the configuration in which measurement stage MST itself can be exchanged, that is, a configuration in which the engagement between the mover and stator of the Y-axis linear that drives the measurement stage in the Y-axis direction can be released can be employed.

In the embodiment above, the case has been described where measurement table MTB is freely detachable to leveling table 52 that constitutes measurement stage MST. The present invention, however, is not limited to this, and for example, the measurement table can be fixed screwed to a part of measurement table MST. Even in such a case, by removing the screw, the measurement table can be exchanged.

Further, in the embodiment above, the case has been described where arrangements in which leveling table 52 has six degrees of freedom and measurement table MTB has three degrees of freedom are employed. The present invention is not limited to this, and arrangements in which leveling table 52 has three degrees of freedom and measurement table MTB has three degrees of freedom can be employed. Further, the arrangement without leveling table 52 and measurement table MTB having six degrees of freedom can also be employed. The point is, any arrangement can be employed as long as at least a part of the measurement section including plate 101 can be exchanged.

In the embodiment above, the case has been described where a piston-shaped self-weight canceller 58 is employed as a mechanism for cancelling the weight of leveling table 52, however, the present invention is not limited to this, and a bellows-shaped self-weight canceller or the like can be employed. Further, self-weight canceller 58 can also be made to cancel the weight of wafer stage main body 28.

### <A Second Embodiment>

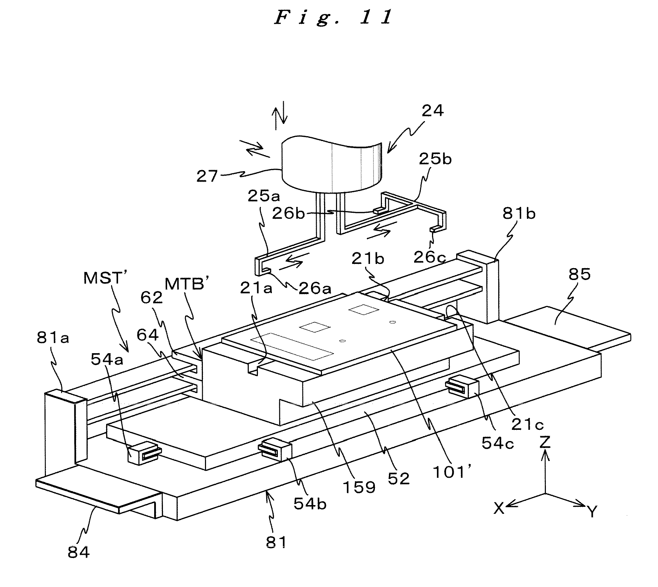

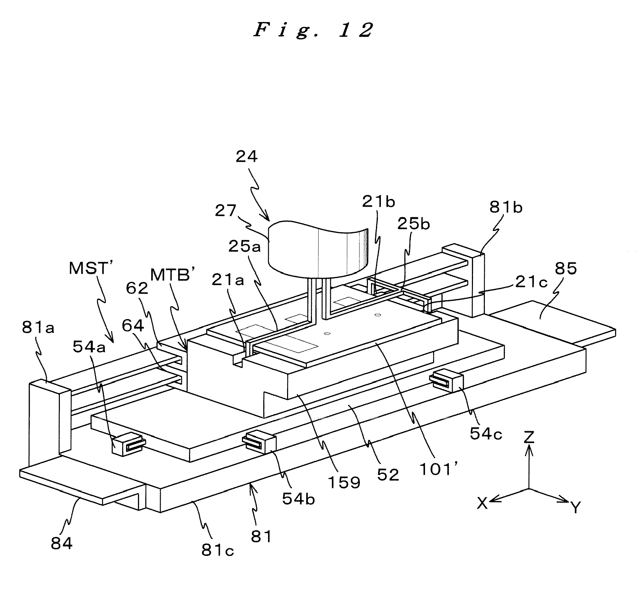

Next, a second embodiment of the present invention will be described, referring to FIGS. 11 and 12. For parts that have the same or similar arrangement as the first embodiment previously described, the same reference numerals will be used, and the description thereabout will be brief, or entirely omitted. In the exposure apparatus of the second embodiment, the configuration or the like of the measurement stage serving as a measurement section differs from the first embodiment previously described. The configuration or the like of other components or assemblies are similar to the first embodiment previously described. Accordingly, from the viewpoint of avoiding repetition in the following description, the differences will mainly be described.

Fig. 11 shows a perspective view of a measurement stage MST' related to the second embodiment. When comparing FIG. 11 and FIG. 3A, it can be seen that in measurement stage MST' of the second embodiment, instead of measurement table MTB of the first embodiment previously described, a measurement table MTB' serving as a measurement unit is arranged. Measurement table MTB' is equipped with a measurement table main body 159 whose configuration is slightly different from measurement table main body 59, and a plate 101' mounted freely detachable on measurement table main body 159. Accordingly, besides these points, measurement table MTB' is basically configured similar to measurement table MTB previously described, and has similar functions.

Similar to the first embodiment above, plate 101' is made of a glass material such as Zerodur (brand name of Schott Corporation), silica glass or the like. On the surface of plate 101', chromium is coated on substantially the entire surface, and in some areas, an area for measurement instruments and a fiducial mark area are formed. And, in the area for the measurement instruments, patterning is applied and aperture patterns for measurement are formed such as an aperture pattern used for aerial image measurement (e.g., a slit-shaped aperture pattern), a pinhole aperture pattern used for irregular illumination measurement, an aperture pattern used for illuminance measurement, an aperture pattern used for wavefront aberration measurement and the like, as in the first embodiment previously described.

Further, on the -Y side edge surface and the -X side edge surface, mirror-polishing is applied so as to form reflection surfaces (corresponding to the reflection surface of movable mirrors 117X and 117Y on measurement table MTB in the first embodiment). Further, also in the second embodiment, various measurements are performed in a state where water is supplied to the space on plate 101', therefore, water-repellent coating is applied on the surface of plate 101' .

In the second embodiment, plate 101' is held by suction on measurement table main body 159 via a vacuum chuck (not shown) arranged in measurement table main body 159. As a matter of course, plate 101' can be fixed to measurement table main body 159 not only by vacuum chucking but also by using a mechanical mechanism.

In measurement table main body 159, the point where a plurality of light-receiving systems that correspond to the various aperture patterns for measurement described earlier are arranged inside is the same as the first embodiment previously described. However, on the upper surface of measurement table main body 159 on the +X side edge surface at the center in the Y-axis direction, a groove 21a is formed extending in the X-axis direction to under the area where plate 101' is mounted, and on the -X side edge surface in the vicinity of both ends in the Y-axis direction, grooves 21b and 21c are respectively formed extending in the X-axis direction to under the area where plate 101' is mounted.

Above measurement stage MST' in FIG. 11, a load/unload mechanism 24 is arranged, which is used for loading/unlcading plate 101'. Load/unload mechanism 24 is actually arranged above base platform 12 close to the edge in the -Y direction.

Load/unload mechanism 24 is equipped with a main body section 27 that can perform a slide operation in the Y-axis direction and an elevating operation in the Z-axis direction, and two hand sections 25a and 25b shaped roughly in a letter L when viewed from the +Y direction attached to main body section 27 that can move in opposite directions in the X-axis direction (movement in a direction where the hand sections draw close together or move apart).

One of the hand section 25a is attached to main body section 27 in a state supported by suspension, in a state where the +X side end projects outside main body section 27, and on the +X side end a hook section 26a is arranged. Further, the other hand section 25b is attached to main body section 27 in a state supported by suspension, in a state where the -X side end projects outside main body section 27, and on the -X side end an extending section that extends in the Y-axis direction is arranged, and on the +Y end and the -Y end of the extending section, hook sections 26b and 26c are arranged. Hook sections 26a, 26b, and 26c are arranged roughly at the same height position.

Hand sections 25a and 25b can freely slide in opposing directions (that is, opens/closes freely) along the X-axis direction by a drive mechanism (not shown) arranged in main body section 27. Load/unload mechanism 24 operates under the control of main controller 20.

The arrangement or the like of other sections are similar to the first embodiment previously described. Therefore, in the exposure apparatus of the second embodiment, the exposure operation and the measurement operation are performed in a sequence similar to the ones described earlier in the first embodiment.

In the second embodiment, as in the first embodiment described above, by an experiment performed in advance, measurement values of the various measurement instruments just before the water-repellent coating deteriorates are obtained, based on a relation between the water-repellent deterioration and the change in measurement results of the various measurement instruments arranged in measurement table MTB', and border values of the measurement results of the various measurement instruments that are about to exceed permissible values are stored in memory MEM as threshold values . And, in the case measurement is performed using measurement table MTB', main controller 20 judges whether or not the exchange timing of plate 101' has arrived by comparing the measurement results with the threshold values stored in memory MEM. That is, in the second embodiment, a detection unit that detects the exchange timing of plate 101' is configured, including main controller 20 and memory MEM.

Further, detection of the exchange timing of plate 101' can also be performed using other methods given in the first embodiment previously described.

In any case, when main controller 20 detects the exchange timing of plate 101' (judges that the exchange timing of plate 101' has arrived), main controller 20 shows that the exchange timing has arrived on display DIS, and then waits for instructions from the operator. Or, when main controller 20 detects the exchange timing of plate 101' (judges that the exchange timing of plate 101' has arrived), main controller 20 shows that the exchange timing has arrived on display DIS, and performs the exchange of plate 101' in the manner described below.

More specifically, after main controller 20 moves load/unload mechanism 24 to the position shown in FIG. 11, main controller 20 drives main body section 27 downward and then inserts hook sections 26a, 26b, and 26c from above into grooves 21a, 21b, and 21c in a state where hand sections 25a and 25b are opened. Then, main controller 20 closes hand sections 25a and 25b by a predetermined amount via the drive mechanism in main body section 27. By this operation, hand section 25a is driven to the -X side and hand section 25b is driven to the +X side, which brings hook section 26a of hand section 25a and hook sections 26b and 26c of hand section 25b to the position under plate 101' , respectively. FIG. 12 shows this state. At this point, hook sections 26b and 26c are not in contact with the edge surface of plate 101' on the -X side.

Then, in the state shown in FIG. 12, main controller 20 stops the vacuum chuck of measurement table main body 159, and after releasing the vacuum chucking of plate 101' main controller 20 drives main body section 27 in the +Z direction and lifts plate 101' with hook sections 26a to 26c. Then, after driving main body section 27 upward to a predetermined height, main controller 20 drive main body section to the -Y side and delivers plate 101' to a carrier system (not shown). Accordingly, plate 101' is carried outside the exposure apparatus, and a new plate 101' is carried to a predetermined position inside the exposure apparatus by the carrier system and delivered to hand section 25a and 25b of load/unload mechanism 24 waiting at the position.

Then, main controller 20 performs a reversed operation of the operation described above, and the new plate 101' is loaded on measurement table main body 159. However, when the new plate 101' is loaded, main controller 20 performs rough position setting, like pushing the edge surface or the like of the new plate 101' on the +X side against a position setting pin (not shown) arranged on measurement table main body 159. And after the position setting has been completed, main controller 20 turns on the vacuum chuck and holds the new plate 101' on measurement table main body 159 by suction.

In this case, as is described earlier, because the edge surface of plate 101' is mirror-polished, even if the position of plate 101' is roughly set in the manner described above, since the position of plate 101' can be accurately measured using the interferometers in the various measurements using measurement stage MST' that will be performed after the rough position setting, the various measurements using measurement stage MST' can consequently be performed with high precision even after the plate exchange.

As is described so far, according to the exposure apparatus of the second embodiment, by obtaining the period just before the measurement accuracy of the various measurement instruments arranged in measurement table MTB' begins to deteriorate by experiment or the like and by setting this period in advance as the exchange timing of measurement table MTB', in the case main controller 20 serving as a detection unit detects the exchange timing and exchanges plate 101', it becomes possible to exchange the plate during the optimum period, which is before the deterioration of the measurement accuracy of the various measurement instruments arranged on measurement table MTB'. That is, the measurement accuracy of the measurements related to exposure performed by measurement table MTB' can be maintained with high precision, and the exchange frequency of the plate can also be suppressed as much as possible. Accordingly, the exposure accuracy can be maintained with high precision over a long period of time, and it also becomes possible to effectively prevent a reduction in the apparatus operation efficiency caused by the increasing downtime that accompanies the plate exchange.

Further, in the second embodiment, because plate 101' has two edge surfaces that are mirror-polished, when plate 101' is exchanged with a new plate, even if the plate that has been exchanged is roughly positioned, the position of the plate can be accurately measured using interferometers 16 and 16 via the edge surfaces of the plate that has been mirror-polished. Accordingly, even if the plate is roughly positioned during the exchange, because it is possible to accurately position measurement table WTB that makes up the measurement section at a desired position on measurement, it is no longer necessary to take a lot of time in the exchange operation, and on this point as well, it becomes possible to effectively prevent a reduction in the apparatus operation efficiency caused by the increasing downtime that accompanies the exchange.

Further, because immersion exposure is performed in the exposure apparatus of the second embodiment, the pattern of reticle R can be transferred onto the wafer with good accuracy.

In the second embodiment above, plate 101' could be exchanged, however, the present invention is not limited to this, and any structure can be employed as long as at least a part of the measurement section including the plate (corresponds to the measurement table in the second embodiment above) can be exchanged.

Further, in the second embodiment above, the edge surfaces of plate 101' were mirror-polished so that only a rough position setting would be necessary when exchanging plate 101'. However, the present invention is not limited to this, and movable mirror 117X and 117Y can be arranged on measurement table main body 159 as in the first embodiment previously described.

Further, in the second embodiment above, since the measurement stage only requires an arrangement where the plate can be exchanged, the arrangement of the other sections of the measurement stage is not limited to the one shown in FIG. 11. For example, a measurement stage that has a configuration like wafer stage WST in FIG. 2 can be employed, and a configuration in which the plate equipped in the measurement stage can be exchanged can be employed.

Further, in the second embodiment above, the case has been described where load/unload mechanism 24 shown in FIG. 11 is employed as a mechanism for exchanging plate 101', however, instead of load/unload mechanism 24, a robot used in a wafer loader or the like can be employed as the load/unload mechanism. In this case, a configuration where the edge of the plate projects out on both sides in the X-axis direction of measurement table MTB' can be employed and the robot arm can lift the plate from below so as to perform plate exchange, or a vertical movement mechanism for moving the plate upward by a predetermined height from measurement table main body 159 can be arranged in measurement table MTB' , and in a state where the plate is lifted by the vertical movement mechanism, the robot arm can be inserted under the plate and the arm can be raised so as to perform plate exchange.

In each of the embodiments above, the case has been described where the present invention is applied to an immersion exposure apparatus. However, even in the case of an exposure apparatus that performs exposure which is not an immersion exposure, it is effective to make at least a part of the measurement section exchangeable as in the first embodiment above (e.g. arranging a measurement table (or a measurement stage) that can be exchanged), to arrange an exchangeable plate and to mirror-polish the edge surface as in the second embodiment above, and further to arrange a detection unit that detects the exchange timing of at least a part of the measurement section including the plate. In this case, water-repellent coating does not have to be applied on the plate, however, by exchanging a part of the measurement section including the plate, decrease in various measurement accuracies caused by deterioration of the plate due to irradiating high-energy exposure light can be effectively prevented.

In each of the embodiments above, a measurement stage that constitutes a measurement section which has measurement table MTB and measurement table MTB' was arranged separately from wafer stage WST. However, the measurement section can be arranged in wafer stage WST. In this case, at least a part of a measurement unit including the plate that constitutes the measurement section is to be made detachable (exchangeable) with respect to wafer stage WST.

In each of the embodiments above, the case has been described where the stage unit is equipped with one wafer stage and one measurement stage. The present invention, however, is not limited to this, and a plurality of wafer stages can be arranged in order to improve the throughput of the exposure operation.

In each of the embodiments described above, pure water (water) is used as the liquid, however, as a matter of course, the present invention is not limited to this. As the liquid, a liquid that is chemically stable, having high transmittance to illumination light IL and safe to use, such as a fluorine-containing inert liquid may be used. As such as a fluorine-containing inert liquid, for example, Fluorinert (the brand name of 3M United States) can be used. The fluorine-containing inert liquid is also excellent from the point of cooling effect. Further, as the liquid, a liquid which has high transmittance to illumination light IL and a refractive index as high as possible, and furthermore, a liquid which is stable against the projection optical system and the photoresist coated on the surface of the wafer (for example, cederwood oil or the like) can also be used. Further, in the case the F₂ laser is used as the light source, fomblin oil may be used as the fluorine containing liquid.

Further, in each of the embodiments above, the liquid that has been recovered may be reused. In this case, it is desirable to arrange a filter in the liquid recovery unit, in the recovery pipes, or the like for removing impurities from the liquid that has been recovered.

In each of the embodiments above, the optical element of projection optical system PL closest to the image plane side is tip lens 91. The optical element, however, is not limited to a lens, and it can be an optical plate (parallel plane plate) used for adjusting the optical properties of projection optical system PL such as aberration (such as spherical aberration, coma, or the like), or it can also simply be a cover glass. The surface of the optical element of projection optical system PL closest to the image plane side (tip lens 91 in the embodiments above) can be contaminated by coming into contact with the liquid (water, in the embodiments above) due to scattered particles generated from the resist by the irradiation of illumination light IL or adherence of impurities in the liquid. Therefore, the optical element is to be fixed freely detachable (exchangeable) to the lowest section of barrel 40, and can be exchanged periodically.

In such a case, when the optical element that comes into contact with the liquid is a lens, the cost for replacement parts is high, and the time required for exchange becomes long, which leads to an increase in the maintenance cost (running cost) as well as a decrease in throughput. Therefore, for example, the optical element that comes into contact with the liquid can be a parallel plane plate, which is less costly than lens 91.

Further, in each of the embodiments above, the case has been described where the present invention is applied to a scanning exposure apparatus by the step-and-scan method or the like. It is a matter of course, that the present invention is not limited to this. More specifically, the present invention can also be applied to a projection exposure apparatus by the step-and-repeat method, and further to an exposure apparatus by the step-and-stitch method, an exposure apparatus by the proximity method and the like.

The usage of the exposure apparatus to which the present invention is applied is not limited to the exposure apparatus used for manufacturing semiconductor devices. For example, the present invention can be widely applied to an exposure apparatus for manufacturing liquid crystal displays which transfers a liquid crystal display deice pattern onto a square shaped glass plate, and to an exposure apparatus for manufacturing organic EL, thin-film magnetic heads, imaging devices (such as CCDs), micromachines, DNA chips or the like. Further, the present invention can also be suitably applied to an exposure apparatus that transfers a circuit pattern onto a glass substrate or a silicon wafer not only when producing microdevices such as semiconductors, but also when producing a reticle or a mask used in exposure apparatus such as an optical exposure apparatus, an EUV exposure apparatus, an X-ray exposure apparatus, or an electron beam exposure apparatus.

Further, the light source of the exposure apparatus in the embodiment above is not limited to the ArF excimer laser, and a pulsed laser light source such as a KrF excimer laser (output wavelength: 248 nm), an F₂ laser (output wavelength: 157 nm), an Ar₂ laser (output wavelength: 126 nm), or an Kr₂ laser (output wavelength: 146 nm), or an ultra high-pressure mercury lamp that generates a bright line such as the g-line (wavelength 436 nm) or the i-line (wavelength 365 nm) can also be used as the light source. Further, a harmonic wave may also be used that is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal. Further, the projection optical system is not limited to a reduction system, and the system may be either an equal magnifying system or a magnifying system.

Further, in each of the embodiments above, illumination light IL of the exposure apparatus is not limited the light having the wavelength equal to or greater than 100nm, and it is needless to say that the light having the wavelength less than 100nm may be used. For example, in recent years, in order to expose a pattern equal to or less than 70nm, an EUV exposure apparatus that uses an SOR or a plasma laser as a light source to generate an EUV (Extreme Ultraviolet) light in a soft X-ray range (such as a wavelength range from 5 to 15 nm), and also uses a total reflection reduction optical system designed under the exposure wavelength (such as 13.5nm) and the reflective type mask has been developed. In the EUV exposure apparatus, the arrangement in which scanning exposure is performed by synchronously scanning a mask and a wafer using a circular arc illumination can be considered.

Semiconductor devices are manufactured through the following steps: a step where the function/performance design of a device is performed; a step where a reticle based on the design step is manufactured; a step where a wafer is manufactured using materials such as silicon; a lithography step where the pattern formed on the mask is transferred onto a photosensitive object by the exposure apparatus described in the embodiment above; a device assembly step (including processes such as dicing process, bonding process, and packaging process); inspection step, and the like. In this case, in the lithography step, because the exposure apparatus in each of the embodiments above is used, exposure with high precision can be achieved for over a long period of time. Accordingly, the productivity of high-integration microdevices on which fine patterns are formed can be improved.

### INDUSTRIAL APPLICABILITY

As is described above, the exposure apparatus and the exposure method, and the device manufacturing method of the present invention is suitable for manufacturing electronic devices such as semiconductor devices (integrated circuits), liquid crystal display devices and the like.

## Claims

1. An exposure apparatus that exposes a substrate via a projection optical system, the apparatus comprising:
a substrate stage that can move with the substrate mounted; and
a measurement section that has a plate on which a liquid is supplied and performs measurement related to the exposure via the projection optical system and the liquid, wherein
the apparatus is configured so that at least a part including the plate that constitutes the measurement section can be exchanged.

2. The exposure apparatus of Claim 1 wherein
the measurement section consists of a measurement unit that has at least a part of the unit arranged on a part of the substrate stage, and some of the components that include at least the plate that constitutes the measurement section unit is attached freely detachable to the substrate stage.

3. The exposure apparatus of Claim 1 wherein
the measurement section comprises
a measurement stage main body that can move within a two-dimensional plane independently from the substrate stage, and
a measurement table main body that holds the plate.

4. The exposure apparatus of Claim 3 wherein
the plate is held detachable from the measurement table main body.

5. The exposure apparatus of Claim 4, the apparatus further comprising:
a leveling table attached on the measurement stage main body, wherein
the measurement table main body is supported finely movable on the leveling table.

6. The exposure apparatus of Claim 5 wherein
the leveling table can be driven in directions of six degrees of freedom, and
the measurement table main body can be driven in directions of three degrees of freedom within a horizontal plane.

7. The exposure apparatus of Claim 3, the apparatus further comprising:
a self-weight compensation mechanism that compensates weight of the measurement table main body.

8. The exposure apparatus of Claim 1 wherein
at least one fiducial mark and at least one pattern used for measurement is formed on the plate, and
the measurement section has a light-receiving system that receives exposure light irradiated on the plate via the projection optical system, via the pattern used for measurement.

9. The exposure apparatus of Claim 8 wherein
a plurality of types of patterns used for measurement are formed on the plate, and
the measurement section has a plurality of the light-receiving systems that correspond to the pattern used for measurement.

10. The exposure apparatus of Claim 9 wherein
the plurality of types of patterns used for measurement include at least one of an aperture pattern used for aerial image measurement, a pinhole aperture pattern used for irregular illumination measurement, an aperture pattern used for illuminance measurement, and an aperture pattern used for wavefront aberration measurement.

11. The exposure apparatus of Claim 1, the apparatus further comprising:
at least one substrate stage different from the substrate stage on which the substrate is mounted.

12. The exposure apparatus of Claim 1, the apparatus further comprising:
a control unit that executes measurement by the measurement section according to an exchange timing of a substrate on the substrate stage.

13. The exposure apparatus of Claim 12 wherein
the control unit executes measurement of specific types, dividing the measurement into a plurality of times according to the exchange timing of the substrate.

14. An exposure apparatus that exposes a substrate via a projection optical system, the apparatus comprising:
a substrate stage that can move with the substrate mounted; and
a measurement section that has a plate on which mirror-polishing is applied on at least one edge surface, and performs measurement related to the exposure via the projection optical system, wherein
the apparatus is configured so that at least a part including the plate that constitutes the measurement section can be exchanged.

15. The exposure apparatus of Claim 14 wherein
the measurement section consists of a measurement unit that has at least a part of the unit arranged on a part of the substrate stage, and some of the components that include at least the plate that constitutes the measurement section unit is attached freely detachable to the substrate stage.

16. The exposure apparatus of Claim 14 wherein
the measurement section comprises
a measurement stage main body that can move within a two-dimensional plane independently from the substrate stage, and
a measurement table main body that holds the plate.

17. The exposure apparatus of Claim 16 wherein
the plate is held detachable from the measurement table main body.

18. The exposure apparatus of Claim 17, the apparatus further comprising:
a leveling table attached on the measurement stage main body, wherein
the measurement table main body is supported finely movable on the leveling table.

19. The exposure apparatus of Claim 18 wherein
the leveling table can be driven in directions of six degrees of freedom, and
the measurement table main body can be driven in directions of three degrees of freedom within a horizontal plane.

20. The exposure apparatus of Claim 17, the apparatus further comprising:
a self-weight compensation mechanism that compensates weight of the measurement table main body.

21. The exposure apparatus of Claim 14 wherein
at least one fiducial mark and at least one pattern used for measurement is formed on the plate, and
the measurement section has a light-receiving system that receives exposure light irradiated on the plate via the projection optical system, via the pattern used for measurement.

22. The exposure apparatus of Claim 21 wherein
a plurality of types of patterns used for measurement are formed on the plate, and
the measurement section has a plurality of the light-receiving systems that correspond to the pattern used for measurement.

23. The exposure apparatus of Claim 22 wherein
the plurality of types of patterns used for measurement include at least one of an aperture pattern used for aerial image measurement, a pinhole aperture pattern used for irregular illumination measurement, an aperture pattern used for illuminance measurement, and an aperture pattern used for wavefront aberration measurement.

24. The exposure apparatus of Claim 14, the apparatus further comprising:
at least one substrate stage different from the substrate stage on which the substrate is mounted.

25. The exposure apparatus of Claim 14, the apparatus further comprising:
a control unit that executes measurement by the measurement section according to an exchange timing of a substrate on the substrate stage.

26. The exposure apparatus of Claim 25 wherein
the control unit executes measurement of specific types, dividing the measurement into a plurality of times according to the exchange timing of the substrate.

27. An exposure apparatus that exposes a substrate via a projection optical system, the apparatus comprising:
a substrate stage that can move with the substrate mounted;
a measurement section that has a plate that can be exchanged, and performs measurement related to the exposure via the projection optical system; and
a detection unit that detects an exchange timing of the plate.

28. The exposure apparatus of Claim 27 wherein
at least one fiducial mark and at least one pattern used for measurement is formed on the plate, and
the measurement section has a light-receiving system that receives exposure light irradiated on the plate via the projection optical system, via the pattern used for measurement.

29. The exposure apparatus of Claim 28 wherein
a plurality of types of patterns used for measurement are formed on the plate, and
the measurement section has a plurality of the light-receiving systems that correspond to the pattern used for measurement.

30. The exposure apparatus of Claim 29 wherein
the plurality of types of patterns used for measurement include at least one of an aperture pattern used for aerial image measurement, a pinhole aperture pattern used for irregular illumination measurement, an aperture pattern used for illuminance measurement, and an aperture pattern used for wavefront aberration measurement.

31. The exposure apparatus of Claim 27, the apparatus further comprising:
at least one substrate stage different from the substrate stage on which the substrate is mounted.

32. The exposure apparatus of Claim 27, the apparatus further comprising:
a control unit that executes measurement by the measurement section according to an exchange timing of a substrate on the substrate stage.

33. The exposure apparatus of Claim 32 wherein
the control unit executes measurement of specific types, dividing the measurement into a plurality of times according to the exchange timing of the substrate.

34. A device manufacturing method that includes a lithography process in which a device pattern is transferred onto a substrate using the exposure apparatus according to any one of Claims 1 to 33.

35. An exposure method in which a substrate is exposed, the method comprising:
an exchange process in which of a measurement section that performs measurement related to the exposure via a plate on which a liquid is supplied, at least a part including the plate is exchanged; and
an exposure process in which measurement related to the exposure is performed using the measurement section after the exchange, and the substrate is exposed reflecting the measurement results.

36. An exposure method in which a substrate is exposed, the method comprising:
an exchange process in which of a measurement section that performs measurement related to the exposure via a plate that has at least one edge surface mirror-polished, at least a part including the plate is exchanged;
a measurement process in which a position of the plate after the exchange is measured via the edge surface, and the measurement is performed using the measurement section; and
an exposure process in which the measurement results are reflected and the substrate is exposed.

37. An exposure method in which a substrate is exposed, the method comprising:
a measurement process in which measurement is performed using a measurement section that performs measurement related to the exposure via a plate;
an exchange process in which an exchange timing of the plate is detected and the plate is exchanged; and
an exposure process in which the substrate is exposed with the measurement results reflected.
